(19) Europäisches Patentamt
European Patent Office
Office européen des brevets

(11) **EP 2 420 853 B1**

(12) **EUROPEAN PATENT SPECIFICATION**

(45) Date of publication and mention
of the grant of the patent:
**09.01.2013 Bulletin 2013/02**

(51) Int Cl.:
***G01R 33/00*** *(2006.01)*

(21) Application number: **11167920.5**

(22) Date of filing: **27.05.2011**

(54) **Analysis apparatus and analysis method**

Analysegerät und Analyseverfahren

Appareil d'analyse et procédé d'analyse

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **18.08.2010 JP 2010183284**

(43) Date of publication of application:
**22.02.2012 Bulletin 2012/08**

(73) Proprietor: **FUJITSU LIMITED
Kawasaki-shi,
Kanagawa 211-8588 (JP)**

(72) Inventor: **Shimizu, Koichi
Kawasaki-shi, Kanagawa 211-8588 (JP)**

(74) Representative: **Lewin, David Nicholas
Haseltine Lake LLP
Lincoln House, 5th Floor
300 High Holborn
London WC1V 7JH (GB)**

(56) References cited:
**US-A1- 2005 075 818**

• **NEWNS DENNIS ET AL: "Efficient techniques for
the computer simulation of magnetic recording
in complex layered materials", JOURNAL OF
APPLIED PHYSICS, AMERICAN INSTITUTE OF
PHYSICS. NEW YORK, US, vol. 95, no. 6, 15 March
2004 (2004-03-15) , pages 3175-3201,
XP012067619, ISSN: 0021-8979, DOI:
10.1063/1.1642288**
• **P-O JUBERT ET AL: "Recording at Large Write
Currents on Obliquely Evaporated Medium and
Application to a Multilevel Recording Scheme",
IEEE TRANSACTIONS ON MAGNETICS, IEEE
SERVICE CENTER, NEW YORK, NY, US, vol. 46,
no. 12, 1 December 2010 (2010-12-01), pages
4059-4065, XP011336735, ISSN: 0018-9464, DOI:
10.1109/TMAG.2010.2083678**

**Description**

FIELD

An embodiment of the invention discussed herein is directed to an analysis apparatus and an analysis method.

BACKGROUND

Conventional analysis apparatuses simulate magnetic fields generated in magnetic materials by modeling the properties of the magnetic materials and by analyzing the properties of the modeled magnetic materials. For example, the analysis apparatuses model the magnetic hysteresis of a magnetic material in accordance with both an M-H curve, which indicates the relation between magnetization M of the magnetic material and an external magnetic field H of the magnetic material, and the coercive force Hc of the magnetic material. Such analysis apparatuses simulate the property of the magnetic material by analyzing the modeled magnetic hysteresis.

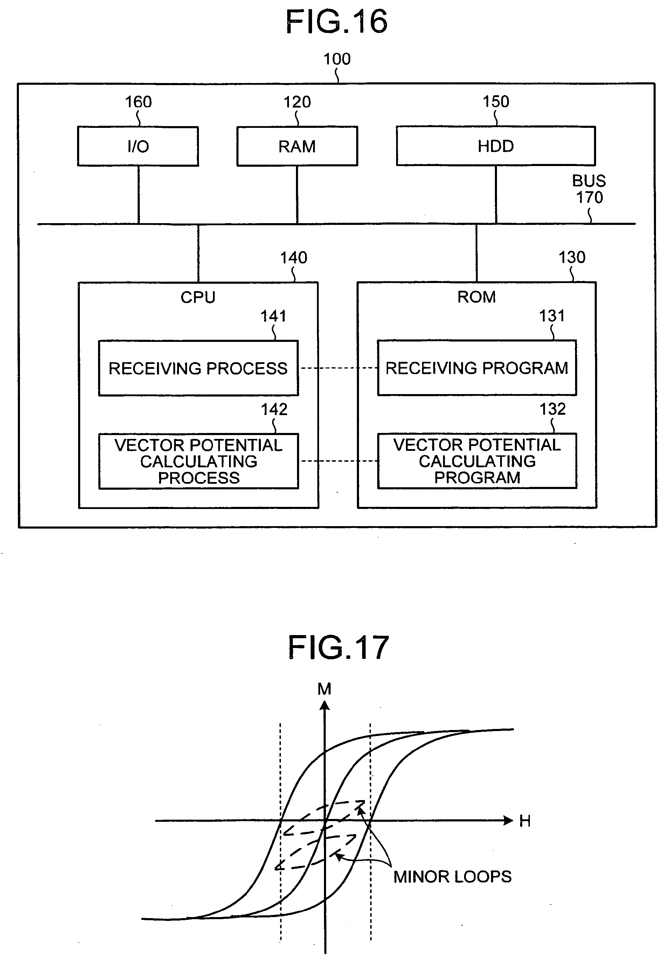

As illustrated in FIG. 17, in some cases, the magnetization M of a magnetic material may vary in such a manner that curves called minor loops are made within the M-H curves. However, the analysis apparatuses do not simulate the minor loops if the analysis apparatuses, in accordance with the previously determined M-H curve and the coercive force Hc, model the magnetic hysteresis of the magnetic material, thus reducing the accuracy of the modeling of the magnetic material. FIG. 17 is a schematic diagram illustrating minor loops.

In such a case, to accurately model the properties of the magnetic materials, there is a known technology, called micro-magnetization analysis, for modeling the properties of the magnetic materials by dividing the magnetic materials into multiple regions and calculating the magnetization state in each divided region.

Specifically, an analysis apparatus that performs a micro-magnetization analysis uses a micro-magnetization vector m in each region of the divided magnetic material. Then, the analysis apparatus solves, as simultaneous equations, both the Landau Lifshitz Gilbert (LLG) equation corresponding to the equation of motion of a micro-magnetization vector m and the equation of a magnetic field representing an external magnetic field H given by a micro-magnetization vector m. More specifically, by solving both the LLG equation and the equation of the magnetic field as the micro-magnetization vector m and the external magnetic field H evolve over time, the analysis apparatus simulates, with high accuracy, the properties of the magnetic materials, including the minor loops.

For example, by using the equation of the magnetic field, the analysis apparatus calculates an external magnetic field $H_t$ given by a micro-magnetization vector $m_t$ at a time t. Then, by using both the calculated external magnetic field $H_t$ and the LLG equation, the analysis apparatus calculates the value of a micro-magnetization vector $m_{t+\Delta t}$ at a time t + $\Delta t$ for which the time has evolved by $\Delta t$ from the time t. By repeatedly performing this calculation, the analysis apparatus simulates the properties of the magnetic materials that temporally vary.

Furthermore, if simultaneous equations include an equation that indicates a non-stationary value, by using the shortest time scale in the time scale used with each equation, the analysis apparatus solves equations by evolving, over time, the non-stationary value. Here, the micro-magnetization vector m has a non-stationary value in terms of the external magnetic field H, and the time scale that is used with the LLG equation is shorter than that used with the equation of the magnetic field.

Accordingly, by using the time scale used with the LLG equation, the analysis apparatus evolves, over time, both the micro-magnetization vector m and the external magnetic field H. For example, if the time scale used with the LLG equation is approximately $10^{-12}$ seconds, the analysis apparatuses calculates, from the external magnetic field $H_t$ at the time t, a micro-magnetization vector at a time t + $10^{-12}$ and then calculates, from the calculated micro-magnetization vector, an external magnetic field at a time t + $10^{-12}$.

However, with the above-described technology that is used for the micro-magnetization analysis, using the time scale used with the LLG equation, both the micro-magnetization vector m and the external magnetic field H are made to evolve over time; therefore, there is a problem in that the period of time for simulating the properties of the magnetic materials is limited to a short period of time.

For example, if the time scale used with the LLG equation is $10^{-12}$ seconds, the analysis apparatus evolves both the micro-magnetization vector m and the external magnetic field H over time at approximate time intervals of $10^{-12}$ seconds. Accordingly, even when the analysis apparatus calculates for a long period of time, it only simulates the properties of the magnetic materials for approximately $10^{-6}$ seconds. Furthermore, if the analysis apparatus simulates the properties of the magnetic materials for several seconds, it cannot complete the calculation in a predetermined period of time; therefore, the analysis apparatus cannot simulate the properties of the magnetic materials for several seconds.

To use a micro-magnetization analysis for a large magnetic material, it is conceivable to use a technology for dividing the magnetic materials into a plurality of meshes and using, as a magnetization vector, the average value of a plurality of micro-magnetization vectors m that are included in the meshes. However, analysis apparatuses that use such a technology evolve, over time, both the micro-magnetization vector m and the external magnetic field H using the time scale used with the LLG equation. Accordingly, the period of time for simulating the properties is limited to a short period of time; therefore, it is impossible to simulate the properties of the magnetic materials for several seconds.

According to an aspect of the disclosed technology, it is possible to simulate the properties of magnetic materials for a long period of time.

Patent Document: Japanese Laid-open Patent Publication No. 2008-275403

US-A1-2005/0075818 discloses a technique to improve the precision of a micromagnetization analysis.

An article published in the Journal of Applied Physics (Vol. 95, No. 6, page 3175) discloses "Efficient techniques for the computer simulation of magnetic recording in complex layered materials".

An article published in the IEEE Transactions on Magnetics, vol. 46, No. 12, December 2010 discloses "Recording at large Write Currents on Obliquely Evaporated Medium and Application to a Multilevel Recording Scheme".

SUMMARY

An analysis apparatus, method, program, and computer readable medium storing the program are defined according to the claims.

calculates an average value of a plurality of magnetization vectors allocated to each region of the object that is obtained by dividing the object to be analyzed in accordance with the received property information of the object to be analyzed, and calculates a vector potential obtained after a predetermined time has elapsed by using the calculated average value of the magnetization vectors and an equation of a magnetic field that is a governing equation of a vector potential.

BRIEF DESCRIPTION OF DRAWINGS

FIG. 1 is a schematic diagram illustrating an information processing apparatus according to a first embodiment;
FIG. 2 is a schematic diagram illustrating an example of a read process performed on a mesh;
FIG. 3 is a schematic diagram illustrating an example of a process for setting analysis conditions;
FIG. 4 is a schematic diagram illustrating an example of a process for setting the properties of an object to be analyzed;
FIG. 5 is a schematic diagram illustrating a calculation in which both the LLG equation and an equation of a stationary magnetic field are evolved over time;
FIG. 6 is a schematic diagram illustrating calculation in which both the LLG equation and an equation of a non-stationary magnetic field are evolved over time;
FIG. 7 is a schematic diagram illustrating an example of simulating minor loops using a micro-magnetization analysis;
FIG. 8 is a schematic diagram illustrating a magnetic field gradient;
FIG. 9 is a schematic diagram illustrating a saturation magnetic field;
FIG. 10 is a schematic diagram illustrating an example of output results;
FIG. 11 is a schematic diagram illustrating an example of a process for evolving time by using an explicit expression M;
FIG. 12 is a schematic diagram illustrating an example of a process for evolving time by using an implicit expression M;
FIG. 13 is a flowchart illustrating the flow of a process for evolving time by using the explicit expression M;
FIG. 14 is a flowchart illustrating the flow of a process for evolving time by using the implicit expression M;
FIG. 15 is a flowchart illustrating the flow of a process that uses a magnetic field gradient to perform time evolution;
FIG. 16 is a functional block diagram illustrating a computer that executes an analysis program; and
FIG. 17 is a flowchart illustrating minor loops.

DESCRIPTION OF EMBODIMENTS

Preferred embodiments of the present invention will be explained with reference to accompanying drawings. In the following, each embodiment will be described as an information processing apparatus that includes the analysis apparatus disclosed in the present invention. Furthermore, in the following description, a micro-magnetization vector m, an average value M of the micro-magnetization vectors m, an external magnetic field H, and a vector potential A are assumed to be vectors.

[a] First Embodiment

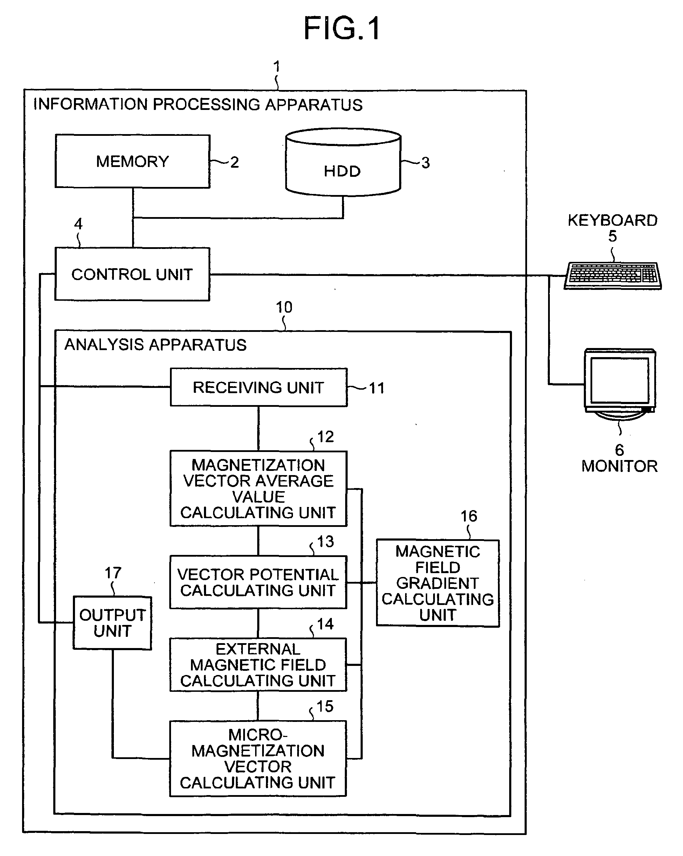

In a first embodiment, an example of an information processing apparatus that includes an analysis apparatus will be described with reference to FIG. 1. FIG. 1 is a schematic diagram illustrating the information processing apparatus according to the first embodiment. The information processing apparatus according to the first embodiment is a computer that simulates, in accordance with an initial value of a micro-magnetization vectors that is input from outside, the properties of a magnetic material.

In the example illustrated in FIG. 1, an information processing apparatus 1 includes a memory 2, a hard disk drive (HDD) 3, a control unit 4, and an analysis apparatus 10. Furthermore, the information processing apparatus 1 is connected to a keyboard 5 and a monitor 6. The memory 2 is a storing unit that temporarily stores therein arbitrary information. The HDD 3 is a storing unit that stores therein arbitrary information. The keyboard 5 is an input device used for inputting property information on an object to be analyzed or inputting settings of the analysis method. The monitor 6 is a display that displays a screen for inputting the property information on the object to be analyzed or inputting analysis results.

The control unit 4 controls the memory 2, the HDD 3, and the analysis apparatus 10 that are included in the information processing apparatus 1. Furthermore, the control unit 4 displays, on the monitor 6, setting screens for dividing the magnetic material into meshes, for analysis conditions, and for the properties of an object to be analyzed. The control unit 4 transmits, to the analysis apparatus 10, various kinds of information that is set by a user. Furthermore, if the control unit 4 obtains an analysis result from the analysis apparatus 10, the control unit 4 displays the obtained analysis result on the monitor 6.

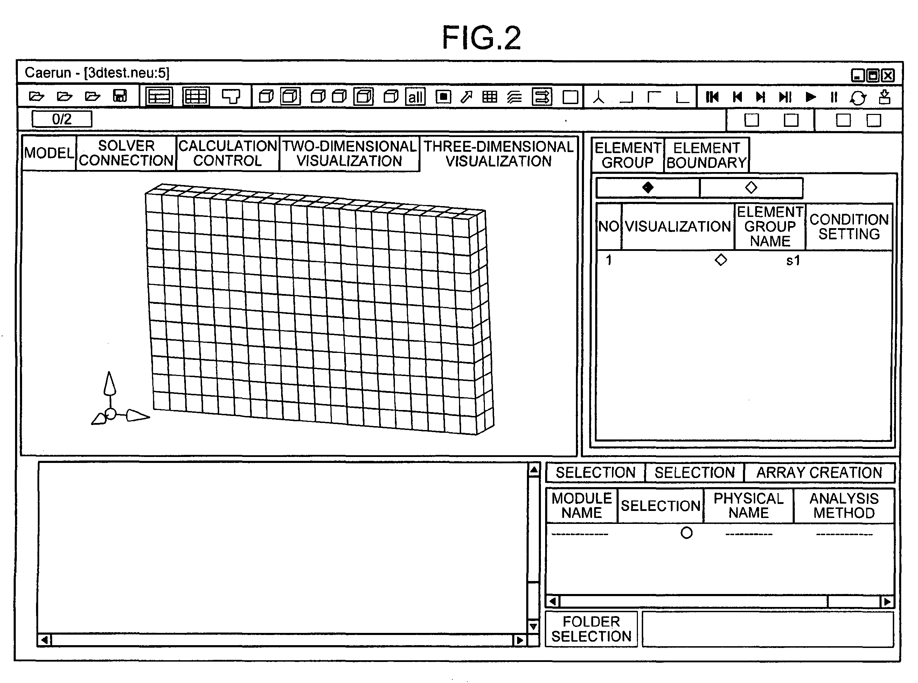

For example, as in the example illustrated in FIG. 2, the control unit 4 displays a setting screen for dividing the magnetic material into meshes, which is an object to be analyzed, on the monitor 6. FIG. 2 is a schematic diagram illustrating an example of a read process performed on a mesh. A user of the information processing apparatus 1 divides, via the setting screen illustrated in FIG. 2, the magnetic material into meshes and sets micro-magnetization vectors m that are allocated to each of the meshes.

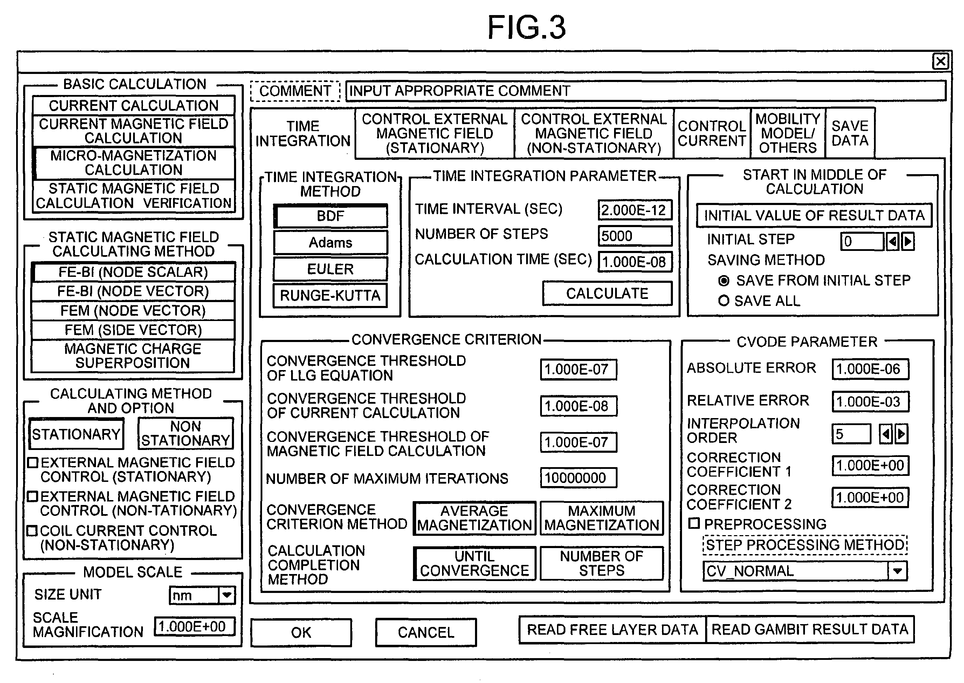

Furthermore, as in the example illustrated in FIG. 3, the control unit 4 displays the setting screen for the analysis conditions on the monitor 6. FIG. 3 is a schematic diagram illustrating an example of a process for setting analysis conditions. In the example illustrated in FIG. 3, the control unit 4 displays, the setting screen for the selection of a basic calculation, a static magnetic field calculating method, a calculating method, and the selection of stationary or non-stationary state; the model scale of the magnetic material; a time integration method; various parameters; and the like on the monitor 6. Furthermore, in the example illustrated in FIG. 3, the control unit 4 displays, the setting screen for convergence criterion, the CVODE (solves initial value problems for an ordinary differential equation) parameter; and the like on the monitor 6.

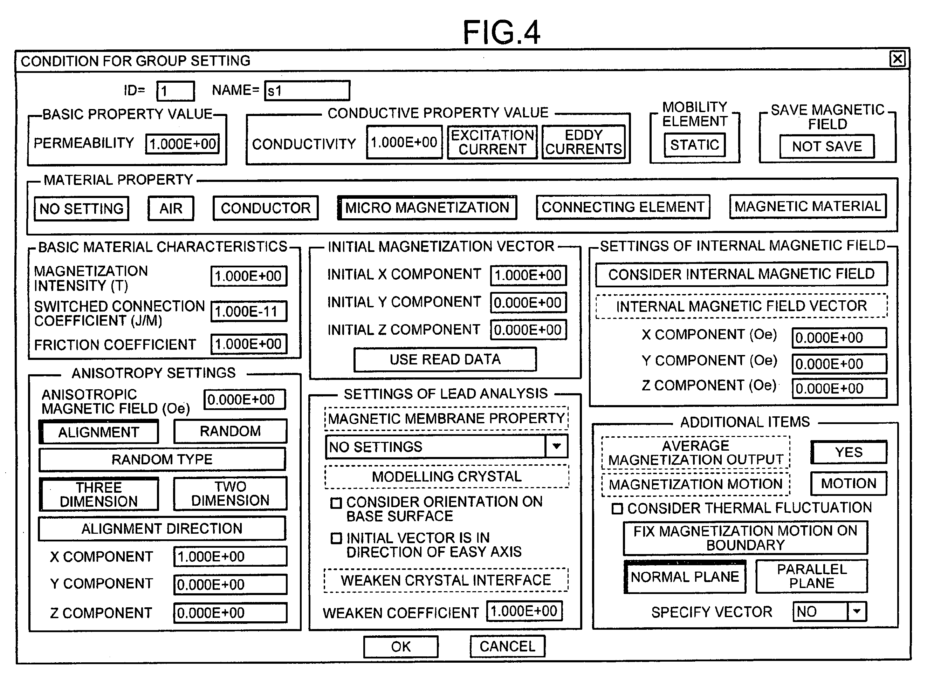

Furthermore, as in the example illustrated in FIG. 4, the control unit 4 displays, the setting screen for property information on an object to be analyzed on the monitor 6. FIG. 4 is a schematic diagram illustrating an example of a process for setting the properties of an object to be analyzed. In the example illustrated in FIG. 4, the control unit 4 displays, the setting screen for a basic property value, a conductive property value, a moving element, storing of the magnetic field, material properties, basic material characteristics, settings of the anisotropy, initial magnetization vectors, settings of the lead analysis, settings of the internal magnetic field, additional items, and the like on the monitor 6.

Then, if a user sets micro-magnetization vectors m, analysis conditions, and property information on an object to be analyzed, the control unit 4 transmits each piece of set information to the analysis apparatus 10.

Referring back to FIG. 1, the analysis apparatus 10 receives an input of property information on an object to be analyzed. Furthermore, the analysis apparatus 10 calculates, in accordance with the received property information on the object to be analyzed, the average value M (hereinafter, referred to as an "average value M") of a plurality of micro-magnetization vectors m that are allocated to the object to be analyzed. Then, using both the calculated average value M and an equation of the magnetic field that is a governing equation of a vector potential A, the analysis apparatus 10 calculates a vector potential A obtained after a predetermined time has elapsed.

In the following, a calculating process performed by the analysis apparatus 10 will be described in detail. The first thing described in the following description will be a process performed by a conventional information processing apparatus in which the Landau Lifshitz Gilbert (LLG) equation, which is an equation of motion of a micro-magnetization vector m, and an equation of the magnetic field representing the external magnetic field H are simultaneously solved. Then, a process performed by the analysis apparatus 10 will be described.

The LLG equation, which is the equation of motion of a micro-magnetization vector m, can be given by Equation (1) below:

$$\frac{\partial m}{\partial t} = -\gamma m \times H_{eff} + \alpha\left(m \times \frac{\partial m}{\partial t}\right) \tag{1}$$

where m is the micro-magnetization vector and $\gamma$ is the gyromagnetic ratio. Furthermore, in Equation (1), $H_{eff}$ is the effective magnetic field given by the micro-magnetization vector and is specifically given by Equation (2) below:

$$H_{eff} = H_{mag} + H_{ex} + H_{aniso} \qquad (2)$$

where $H_{mag}$ is the magnetic field formed by the micro-magnetization vector m. Furthermore, $H_{ex}$ is the switched connection magnetic field. Furthermore, $H_{aniso}$ is the anisotropic magnetic field.

In the following, an equation of the magnetic field representing the external magnetic field H will be described. The equation of the magnetic field representing the external magnetic field H includes both the equation of the stationary magnetic field and the equation of the non-stationary magnetic field. The equation of the stationary magnetic field includes both a governing equation of a scalar potential and a governing equation of a vector potential. Specifically, the governing equation of the scalar potential can be given by Equation (3) and Equation (4) below. In Equation (3), $\Delta$ is the Laplace operator, $\phi$ is the scalar potential, and V is the vector differential operator.

$$\Delta\phi = \nabla \cdot m \qquad (3)$$

$$H_{mag} = -\nabla\phi \qquad (4)$$

Furthermore, the governing equation of the vector potential can be given by Equation (5) and Equation (6) below. In Equation (5), A is the vector potential, $\mu_0$ is the vacuum permeability, and J is the vector representing the excitation current.

$$\nabla \times \nabla \times A = \mu_0 J + \nabla \times m \qquad (5)$$

$$H_{mag} = \frac{1}{\mu_0} \nabla \times A \qquad (6)$$

The governing equation of the scalar potential can take into consideration the effect of the magnetic field generated by the excitation current, whereas the governing equation of the vector potential can take into consideration the effect of the magnetic field generated by the excitation current.

Furthermore, the equation of the non-stationary magnetic field can be given by Equation (7) below. In Equation (7), $\sigma$ is the conductivity. The equation of the non-stationary magnetic field is an equation taking into consideration the contribution of eddy currents and is represented as the governing equation of the vector potential A.

$$\mu_0\sigma \frac{\partial A}{\partial t} + \nabla \times \nabla \times A = \mu_0 J + \nabla \times m \qquad (7)$$

When simultaneously solving the LLG equation and the governing equation of the stationary scalar potential, the conventional information processing apparatus solves the LLG equation and the governing equation of the stationary scalar potential by treating Equation (1) to Equation (4) as simultaneous equations and then solving the LLG equation and the governing equation of the stationary scalar potential as the micro-magnetization vector m and the external magnetic field H evolve over time. Furthermore, when simultaneously solving the LLG equation and the governing equation of the stationary vector potential, the conventional information processing apparatus solves them by treating Equation (1), Equation (2), Equation (5), and Equation (6) as simultaneous equations and then solving them as the micro-magnetization vector m and the external magnetic field H evolve over time.

Furthermore, when simultaneously solving the LLG equation and governing equation of the non-stationary vector potential, the conventional information processing apparatus solves them by treating Equation (1), Equation (2), Equation (6), and Equation (7) as simultaneous equations and then solving them as the micro-magnetization vector m and the external magnetic field H evolve over time.

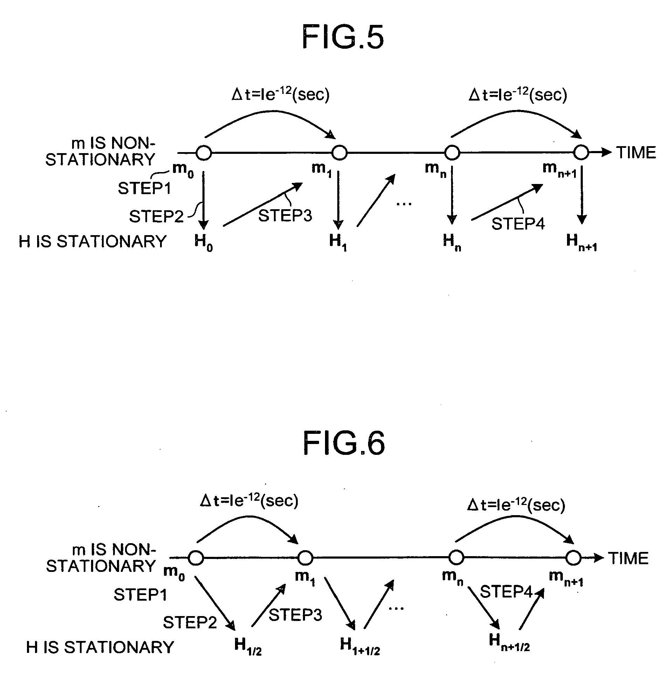

In the following, there will be a description with reference to FIG. 5 of a process, performed by the conventional information processing apparatus, in which the LLG equation and the equation of the stationary magnetic field are solved by treating them as simultaneous equations as the micro-magnetization vector m and the external magnetic field H evolve over time. FIG. 5 is a schematic diagram illustrating a calculation in which both the LLG equation and an equation of a stationary magnetic field are evolved over time. In the example illustrated in FIG. 5, it is assumed that the conventional information processing apparatus solves the equations, using an explicit method, as the micro-magnetization vector m and the external magnetic field H evolve over time.

First, the conventional information processing apparatus obtains, as an initial value, a micro-magnetization vector $m_0$ at a time 0 (Step 1 in FIG. 5). Then, the conventional information processing apparatus calculates, using the micro-magnetization vector $m_0$ at the time 0, an external magnetic field $H_0$ at the time 0 (Step 2 in FIG. 5). Subsequently, by using the calculated external magnetic field $H_0$ as an effective magnetic field $H_{eff}$ given by the micro-magnetization vector m, the conventional information processing apparatus calculates a micro-magnetization vector $m_1$ at the subsequent time step, (Step 3 in FIG. 5).

Specifically, the conventional information processing apparatus calculates the external magnetic field $H_n$ from the micro-magnetization vector $m_n$ and then calculates, from the calculated external magnetic field $H_n$, the micro-magnetization vector $m_{n+1}$ obtained after a predetermined time has elapsed. By repeatedly performing such a series of calculations, the conventional information processing apparatus calculates as the micro-magnetization vector m and the external magnetic field H evolve over time (Step 4 in FIG. 5).

In the following, there will be a description with reference to FIG. 6 of a process, performed by the conventional information processing apparatus, in which the LLG equation and the equation of the non-stationary magnetic field both are solved by treating them as simultaneous equations as the micro-magnetization vector m and the external magnetic field H evolve over time. FIG. 6 is a schematic diagram illustrating calculation in which both the LLG equation and an equation of a non-stationary magnetic field are evolved over time. In the example illustrated in FIG. 6, it is assumed that the conventional information processing apparatus uses an implicit method to solve the equations as the micro-magnetization vector m and the external magnetic field H evolve over time.

First, the conventional information processing apparatus obtains, as an initial value, a micro-magnetization vector $m_0$ at a time 0 (Step 1 in FIG. 6). Then, the conventional information processing apparatus calculates, using the micro-magnetization vector $m_0$, an external magnetic field $H_{1/2}$ in which the time step is advanced by a half step (Step 2 in FIG. 6). Subsequently, the conventional information processing apparatus calculates, using the external magnetic field $H_{1/2}$, a micro-magnetization vector $m_1$ in which a time step is further advanced by a half step (Step 3 in FIG. 6). By repeatedly performing such a series of calculations, the conventional information processing apparatus sequentially calculates as the micro-magnetization vector m and the external magnetic field H evolve over time (Step 4 in FIG. 6).

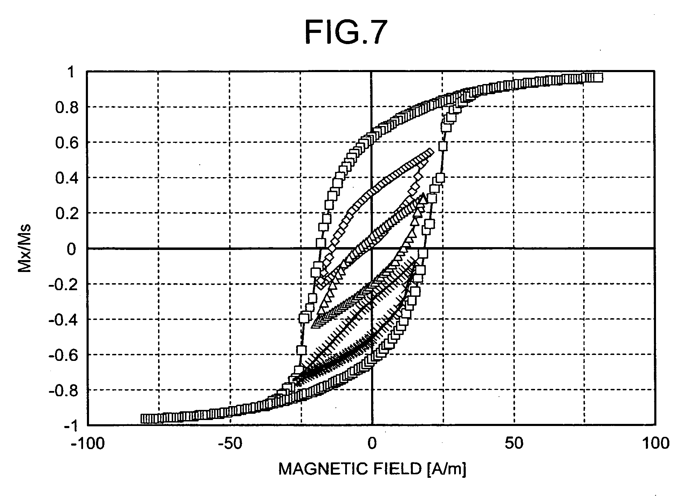

In this way, the conventional information processing apparatus treats the LLG equation and the equation of the magnetic field as simultaneous equations and simultaneously solves the equations by evolving them over time so that the apparatus simulates the properties of the magnetic material. For example, as illustrated in FIG. 7, the conventional information processing apparatus simulates minor loops produced within the M-H curves. FIG. 7 is a schematic diagram illustrating an example of simulating minor loops using a micro-magnetization analysis.

However, as described above, the conventional information processing apparatus solves the LLG equation and the equation of the magnetic field by making both the micro-magnetization vector m and the external magnetic field H evolve over time using the time scale used with the LLG equation. Accordingly, the conventional information processing apparatus limits the period of time for simulating the properties of the magnetic material to a short period of time. For example, in the examples illustrated in FIGS. 5 and 6, the conventional information processing apparatus evolves time only by $10^{-12}$ seconds for each single time step. Accordingly, the conventional information processing apparatus cannot simulate the properties of the magnetic material for several seconds.

In the following, a calculating process performed by the analysis apparatus 10 according to the first embodiment will be described. First, an explicit method will be described in which equations are simultaneously solved by explicitly representing the average value M of the micro-magnetization vectors m. The analysis apparatus 10 calculates the average value M of the micro-magnetization vectors m allocated to the object to be analyzed (hereinafter, referred to as "average value M") using Equation (8) below:

$$ M = \frac{1}{N} \sum_{i=1}^{N} m_i \qquad\qquad (8) $$

At this stage, if the average value M of the micro-magnetization vectors m is explicitly represented by using the vector potential A, it is possible to obtain Equation (9) below. In Equation (9), $A^{n+1}$ is the vector potential A at the

$n+1$th time step. Furthermore, $M^n$ is the average value M at the $n$th time step.

$$\left(\frac{\mu_0\sigma}{\Delta t} - \nabla^2\right)A^{n+1} = \frac{\mu_0\sigma}{\Delta t}A^n + \nabla \times M^n \tag{9}$$

Then, if Equation (9) is transformed using an inverse matrix, it is possible to obtain Equation (10) below:

$$A^{n+1} = \left(\frac{\mu_0\sigma}{\Delta t} - \nabla^2\right)^{-1}\left(\frac{\mu_0\sigma}{\Delta t}A^n + \nabla \times M^n\right) \tag{10}$$

Specifically, if the average value M is explicitly represented, the analysis apparatus 10 solves Equation (9) from the average value $M^n$ at the $n$th time step and calculates, in a single calculation, the vector potential $A^{n+1}$ at the $n+1$th time step.

Because the time scale in which the average value M varies is much shorter than the time scale in which the vector potential A varies, the average value M can be assumed to be stationary during a period of time in which the vector potential $A^n$ changes to $A^{n+1}$. Specifically, the average value $M^n$ can be assumed to be in the stationary state with respect to an external magnetic field $H^{n+1}$ calculated from $A^{n+1}$.

As a result, because, in the calculation performed as the vector potential $A^n$ evolves over time by $A^{n+1}$, the average value M can be assumed to be in the stationary state, the analysis apparatus 10 can evolve the LLG equation over time for a long time scale over which the equation of the magnetic field is made to evolve. Specifically, because the analysis apparatus 10 calculates, from the average value $M^n$, the vector potential $A^{n+1}$ obtained after a predetermined time has elapsed, the analysis apparatus 10 evolves both the vector potential A and the average value M over time for a long time scale over which the vector potential A evolve.

Here, the time scale over which the vector potential A is made to evolve is, for example, approximately $10^{-6}$ seconds. Furthermore, the time scale over which the micro-magnetization vector m is made to evolve over time is, for example, approximately $10^{-12}$ seconds. Specifically, because the analysis apparatus 10 evolves the micro-magnetization vector m and the vector potential A over time for a long time scale, the analysis apparatus 10 can simulate the properties of the magnetic material over a long period of time.

In the following, if the analysis apparatus 10 calculates the vector potential $A^{n+1}$ using the average value $M^n$, the analysis apparatus 10 calculates the external magnetic field $H^{n+1}$ using the calculated vector potential $A^{n+1}$, Equation (11), and Equation (12) below:

$$B^{n+1} = \nabla \times A^{n+1} \tag{11}$$

$$H^{n+1} = \frac{1}{\mu_0}B^{n+1} \tag{12}$$

Then, the analysis apparatus 10 uses Equation (1) with the calculated external magnetic field $H^{n+1}$ and then calculates the average value $M^{n+1}$. If the analysis apparatus 10 further evolves the average value $M^{n+1}$ over time, the analysis apparatus 10 repeats the process for sequentially solving Equation (10) to Equation (12) and calculates the average value $M^{n+2}$ at the subsequent time step.

At this stage, if the time intervals for evolving the simultaneous equations over time are large, to avoid the degradation of the calculation accuracy, the analysis apparatus 10 performs a calculation using an implicit method, in which the average value M is implicitly represented and both the average value M and the vector potential A are made to evolve over time. For example, if the vector potential A and the average value M are represented using a central difference with respect to time, Equation (13) below is given:

$$\mu_0\sigma \frac{A^{n+1} - A^n}{\Delta t} - \frac{\nabla^2\left(A^n + A^{n+1}\right)}{2} = \frac{\nabla \times \left(M^n + M^{n+1}\right)}{2} \qquad (13)$$

If the average value M is implicitly treated, a calculation is repeatedly performed, using $A^{n+1}_1 = A^{n+1}_0 + \delta A$, until $\delta A$ becomes "0" or until $\delta A$ converges to a predetermined threshold $\varepsilon$ or below. Specifically, the analysis apparatus 10 treats a value obtained by adding $A^{n+1}_0$ to an increment $\delta A$ of the vector potential A as a new vector potential $A^{n+1}_1$; calculates, using the vector potential $A^{n+1}_1$, an average value $M_1$; and then calculates a new $\delta A$ using the calculated $M_1$. Then, the analysis apparatus 10 repeatedly performs a series of calculations until the calculated new $\delta A$ becomes "0" or it converges to a predetermined threshold $\varepsilon$ or below.

Here, it is assumed that $A^{n+1}_0$ represents the vector potential $A^{n+1}$ that has not been subjected to the repeated calculations for converging $\delta A$. In the following description, it is assumed that $A^{n+1}_i$ represents the calculated vector potential $A^{n+1}$ that is obtained after the repeated calculations for converging $\delta A$ are performed "i" times.

If $A^{n+1} = A^{n+1} + \delta A$ is used with Equation (13) and Equation (13) and is represented in the nonlinear and non-stationary incremental modes, Equation (14) below can be obtained:

$$\mu_0\sigma \frac{\left(A^{n+1} + \delta A\right) - A^n}{\Delta t} - \frac{\nabla^2\left(A^n + \left(A^{n+1} + \delta A\right)\right)}{2} = \frac{\nabla \times \left(M^n + M^{n+1}\right)}{2} \qquad (14)$$

Furthermore, if Equation (14) is transformed to a linear equation of $\delta A$, Equation (15) below can be obtained:

$$\left(\frac{\mu_0\sigma}{\Delta t} - \frac{1}{2}\nabla^2\right)\delta A = \frac{\mu_0\sigma\left(A^{n+1} - A^n\right)}{\Delta t} + \frac{\nabla^2\left(A^n + A^{n+1}\right)}{2} + \frac{\nabla \times \left(M^n + M^{n+1}\right)}{2}$$

$$(15)$$

Accordingly, the increment $\delta A$ of the vector potential A can be given by Equation (16) below:

$$\delta A = -\left(\frac{\mu_0\sigma}{\Delta t} - \frac{1}{2}\nabla^2\right)^{-1}\left[\frac{\mu_0\sigma\left(A^{n+1} - A^n\right)}{\Delta t} + \frac{\nabla^2\left(A^n + A^{n+1}\right)}{2} + \frac{\nabla \times \left(M^n + M^{n+1}\right)}{2}\right]$$

$$(16)$$

By using the average value $M^n$ in Equation (16), the analysis apparatus 10 calculates $\delta A$ and calculates, from the calculated $\delta A$, new $A^{n+1}_1 = A^{n+1}_0 + \delta A$. Then, the analysis apparatus 10 calculates, from the new $A^{n+1}_1$ using Equation (13), the average value $M_1$ and calculates new $\delta A$ from the calculated average value $M_1$. Furthermore, the analysis apparatus 10 calculates, from the calculated $\delta A$, $A^{n+1}_2 = A^{n+1}_1 + \delta A$. By repeatedly performing the calculations until $\delta A$ becomes "0" or $\delta A$ converges to a predetermined threshold $\varepsilon$ or below, the analysis apparatus 10 can evolve both the average value M and the vector potential A over time.

As described above, because the time scale in which the average value M varies is much shorter than the time scale in which the vector potential A varies, the average value M can be assumed to be stationary during a period of time in which the vector potential $A^n$ changes to $A^{n+1}$. Specifically, in the repeated calculations from $A^{n+1}_0$ to $A^{n+1}_n$, the average value $M^n$ can be assumed to be in the stationary state with respect to the external magnetic field $H^{n+1}$.

As a result, in the repeated calculations performed as the vector potential $A^n$ evolves over time by $A^{n+1}$, the analysis apparatus 10 can evolve both the vector potential A and the micro-magnetization vector m over time for a long time scale over which the vector potential A evolves.

In the following, a calculating method will be described in which, when calculations are repeatedly performed using Equation (15), a gradient of a governing equation is used to speed up the convergence of the increment $\delta A$. For example, if a term taking into consideration the gradient of the average value M is added to Equation (15), Equation (17) below is obtained.

$$\left(\frac{\mu_0\sigma}{\Delta t} - \frac{1}{2}\nabla^2 + \frac{1}{2}\frac{\partial}{\partial A}\nabla \times M^n\right)\delta A$$

$$= -\frac{\mu_0\sigma(A^{n+1} - A^n)}{\Delta t} + \frac{\nabla^2(A^n + A^{n+1})}{2} + \frac{\nabla \times (M^n + M^{n+1})}{2} \qquad (17)$$

At this stage, if variable transformation is performed on the differentiation of the average value M, Equation (18) below is obtained.

$$\frac{\partial}{\partial A}\nabla \times M = \frac{\partial B}{\partial A}\frac{\partial}{\partial B}\nabla \times M = \frac{\partial B}{\partial A}\nabla \times \frac{\partial M}{\partial B} = \frac{1}{\mu_0}\frac{\partial B}{\partial A}\nabla \times \frac{\partial M}{\partial H} \qquad (18)$$

Because the analysis apparatus 10 cannot analytically calculate $\delta M/\delta H$, the analysis apparatus 10 calculates $\Delta M/\Delta H$ by calculating an average value $M^*$ in which the external magnetic field is set as $H = H + \Delta H$ and using an equation $\Delta M = M^* - M$. In the calculation of $\Delta M/\Delta H$, a value $\Delta H$ obtained at the previous time step is used for $\Delta H$. Specifically, $\Delta M/\Delta H$ is calculated using Equation (19) below:

$$\frac{\partial M}{\partial H} = \frac{\Delta M}{\Delta H} = \frac{M^{n+1} - M^n}{\Delta H^n} \qquad (19)$$

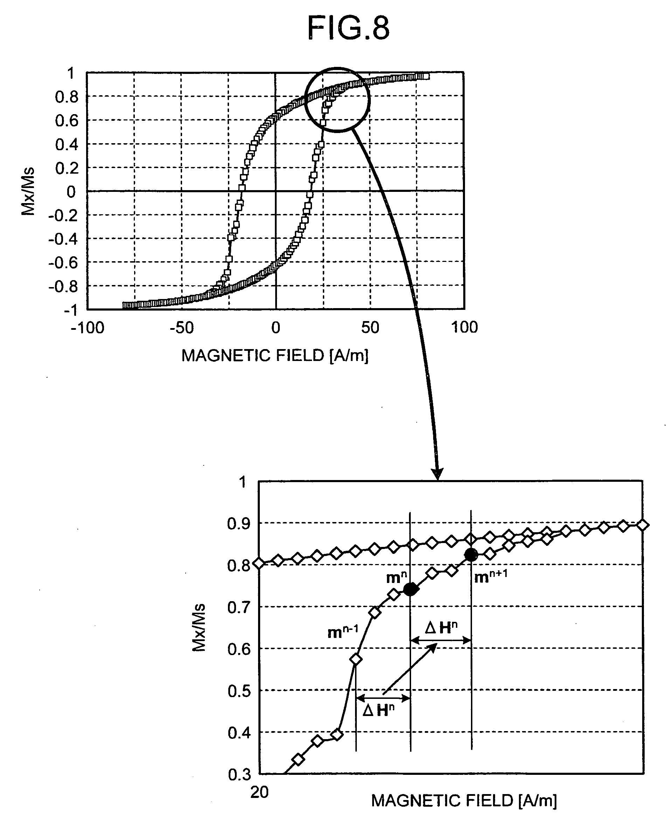

If the analysis apparatus 10 performs the calculation using Equation (17) that takes into consideration the gradient term of such an average value M, the convergence speed of $\delta A$ becomes fast; therefore, it is possible to evolve, over time at a faster pace, the vector potential A and the average value M. For example, in the example illustrated in FIG. 8, the analysis apparatus 10 sets a value, which is obtained by dividing the difference between $M^{n+1}$ and $M^n$ by $\Delta H^n$ obtained at the previous time step, as the gradient of the average value M. FIG. 8 is a schematic diagram illustrating the magnetic field gradient.

Because the number of calculated average values M is finite, the M-H curves are not smooth and have minute irregularities. Because the gradient of the average values M is not accurate if the irregularities on the M-H curve are large, in some cases, the analysis apparatus 10 cannot converge $\delta A$ at a high speed.

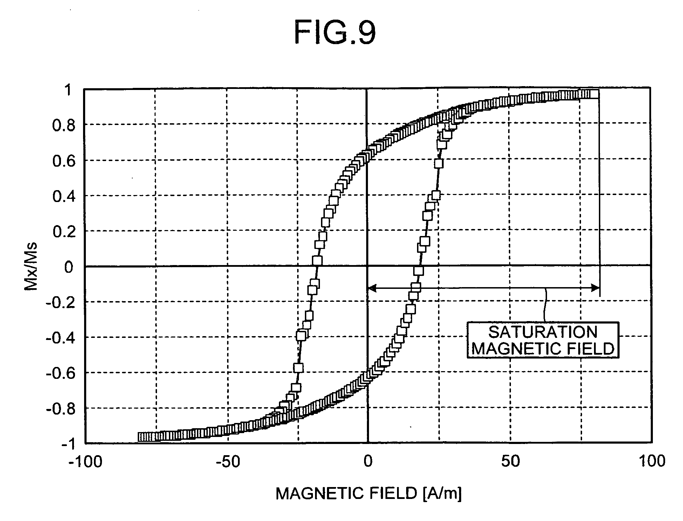

Accordingly, the analysis apparatus 10 calculates $\delta H$ by dividing a saturation magnetic field of the object to be analyzed by the number of average values M. For example, the analysis apparatus 10 obtains the saturation magnetic field $H_{sat}$ illustrated in FIG. 9. FIG. 9 is a schematic diagram illustrating the saturation magnetic field.

Then, if the sum of $\delta H$ and a predetermined coefficient $\alpha$ is smaller than $\Delta H$, the analysis apparatus 10 estimates that the irregularities on the M-H curves are within the variation of $\Delta H$ and calculates an increment $\delta A$ using Equation (17). In contrast, if the sum of $\delta H$ and a predetermined coefficient $\alpha$ is greater than $\Delta H$, the analysis apparatus 10 determines that the analysis apparatus 10 picks up the irregularities on the M-H curves and thus calculates the increment $\delta A$ using Equation (16).

Specifically, by appropriately using Equation (8) to Equation (19) above, the analysis apparatus 10 calculates the vector potential A that is made to evolve over time using the average value M.

In the following, processes performed by each units included in the analysis apparatus 10 will be described. In the following description, it is assumed that the analysis apparatus 10 obtains, from the control device 4, $m^0$ as initial values of the plurality of micro-magnetization vectors m.

Referring back to FIG. 1, the analysis apparatus 10 includes a receiving unit 11, a magnetization vector average value calculating unit 12, a vector potential calculating unit 13, an external magnetic field calculating unit 14, a micro-magnetization vector calculating unit 15, a magnetic field gradient calculating unit 16, and an output unit 17.

The receiving unit 11 receives an input of property information on an object to be analyzed. For example, if the receiving unit 11 receives, from the control unit 4, a plurality of micro-magnetization vectors $m^0$ that are set by a user, the receiving unit 11 transmits, to the magnetization vector average value calculating unit 12, the obtained micro-magnetization vectors $m^0$, the analysis conditions, and property information on the object to be analyzed.

The magnetization vector average value calculating unit 12 calculates, in accordance with the property information on the object to be analyzed received by the receiving unit 11, the average value $M^0$ of the micro-magnetization vectors $m^0$ allocated to the object to be analyzed. Specifically, the magnetization vector average value calculating unit 12 obtains, from the receiving unit 11, the micro-magnetization vectors $m^0$, the analysis conditions, and the property information on the object to be analyzed. Then, using Equation (8), the magnetization vector average value calculating unit 12 calculates the average value $M^0$ from the obtained micro-magnetization vectors $m^0$. Thereafter, the magnetization vector average value calculating unit 12 transmits, to the vector potential calculating unit 13, the calculated average value $M^0$, the analysis conditions, and the property information on the object to be analyzed.

Furthermore, if the magnetization vector average value calculating unit 12 obtains a plurality of micro-magnetization vectors $m^n$ calculated by the micro-magnetization vector calculating unit 15, which will be described later, the magnetization vector average value calculating unit 12 calculates an average value $M^n$ of the obtained micro-magnetization vectors m. Then, the magnetization vector average value calculating unit 12 transmits the calculated average value $M^n$ to the vector potential calculating unit 13.

By using the average value M calculated by the magnetization vector average value calculating unit 12 and using an equation of the magnetic field that is a governing equation of the vector potential A, the vector potential calculating unit 13 calculates a vector potential A obtained after a predetermined time has elapsed.

In the following, a process performed by the vector potential calculating unit 13 will be specifically described. The first thing described in the following description will be a process in which the vector potential calculating unit 13 determines whether it treats the average value M explicitly or implicitly. Then, a process performed when the average value M is explicitly treated will be described, and then a process performed when the average value M is implicitly treated will be described.

First, a process in which the vector potential calculating unit 13 determines whether it treats the average value M explicitly or implicitly will be described. For example, the vector potential calculating unit 13 obtains, from the micro-magnetization vector calculating unit 15, the average value $M^0$, the analysis conditions, and the property information on the object to be analyzed.

Then, when the vector potential calculating unit 13 obtains both the analysis conditions and the property information on the object to be analyzed, the vector potential calculating unit 13 determines, in accordance with the obtained analysis conditions and the property information on the object to be analyzed, the time scale over which both the LLG equation and the equation of the magnetic field evolve. Then, if the time scale over which both the LLG equation and the equation of the magnetic field evolve is shorter than a predetermined threshold, the vector potential calculating unit 13 determines to explicitly treat the average value M. In contrast, if the time scale over which both the LLG equation and the equation of the magnetic field evolve is greater than a predetermined threshold, the vector potential calculating unit 13 determines to implicitly treat the average value M.

In the following, a process in which the vector potential calculating unit 13 explicitly treats the average value M will be specifically described. If the vector potential calculating unit 13 explicitly treats the average value M, the vector potential calculating unit 13 solves, using the average value $M^0$ obtained from the magnetization vector average value calculating unit 12, Equation (10) and calculates the vector potential $A^1$ obtained after a predetermined time has elapsed. Then, the vector potential calculating unit 13 transmits the calculated vector potential $A^1$ to the external magnetic field calculating unit 14.

Furthermore, the vector potential calculating unit 13 obtains a new average value M (for example, an average value $M^n$ at the $n^{th}$ time step) calculated by the magnetization vector average value calculating unit 12. Then, the vector potential calculating unit 13 solves Equation (10) using the average value $M^n$ and calculates the vector potential $A^{n+1}$ obtained after a predetermined time has elapsed. Then, the vector potential calculating unit 13 transmits the calculated vector potential $A^{n+1}$ to the external magnetic field calculating unit 14.

In the following, a process in which the vector potential calculating unit 13 implicitly treats the average value M will be specifically described. First, if the vector potential calculating unit 13 determines to implicitly treat the average value M, the vector potential calculating unit 13 calculates the above-described $\delta H$ and $\Delta H$ and determines whether the sum of the calculated $\delta H$ and a predetermined coefficient $\alpha$ (for example, $\alpha$ = "3") is greater than $\Delta H$.

If the vector potential calculating unit 13 determines that the sum of $\delta H$ and the predetermined coefficient $\alpha$ is greater than $\Delta H$, the vector potential calculating unit 13 solves Equation (16) using the average value $M^0$ and calculates an increment $\delta A$ of the vector potential. Then, the vector potential calculating unit 13 transmits the calculated $\delta A$ to the magnetic field gradient calculating unit 16.

In contrast, if the vector potential calculating unit 13 determines that the sum of $\delta H$ and the predetermined coefficient is smaller than $\Delta H$, the vector potential calculating unit 13 obtains the magnetic field gradient from the magnetic field gradient calculating unit 16, which will be described later. Then, by solving Equation (17) using the obtained magnetic field gradient and the average value $M^0$, the vector potential calculating unit 13 calculates the increment $\delta A$ of the vector potential. Then, the vector potential calculating unit 13 transmits the calculated $\delta A$ to the magnetic field gradient calculating unit 16.

Furthermore, when the vector potential calculating unit 13 calculates the increment $\delta A$ of the vector potential, the vector potential calculating unit 13 determines whether the absolute value of the calculated increment $\delta A$ is smaller than the predetermined threshold $\varepsilon$. If the vector potential calculating unit 13 determines that the absolute value of the calculated increment $\delta A$ is greater than the predetermined threshold $\varepsilon$, the vector potential calculating unit 13 calculates a new vector potential $A^{n+1}_1$ by adding the vector potential $A^{n+1}_0$ to the increment $\delta A$.

Furthermore, if the vector potential calculating unit 13 calculates the new vector potential $A^{n+1}_1$, the vector potential calculating unit 13 calculates, by solving Equation (1), Equation (6), and Equation (8) using the calculated vector potential $A^{n+1}_1$, a new average value $M_1$. Then, the vector potential calculating unit 13 solves, using the average value $M_1$, Equation (16) so that it calculates an increment $\delta A$ of the new vector potential. The vector potential calculating unit 13 repeatedly performs a series of calculations until the absolute value of the increment $\delta A$ of the vector potential becomes smaller than the predetermined threshold $\varepsilon$.

In contrast, if the vector potential calculating unit 13 determines that the absolute value of the increment $\delta A$ is smaller than the predetermined threshold $\varepsilon$, the vector potential calculating unit 13 transmits, as the vector potential $A^{n+1}$ to the external magnetic field calculating unit 14, $A^{n+1}_i$ calculated in the previous repeated calculation (for example, calculated at the ith time). Furthermore, the vector potential calculating unit 13 transmits, as the vector potential $A^{n+1}$ to the magnetic field gradient calculating unit 16, the calculated $A^{n+1}_i$.

In this way, the vector potential calculating unit 13 calculates, using the average value M, a vector potential A at the subsequent time step. Furthermore, as described above, the average value M can be assumed to be stationary with respect to the vector potential A. Accordingly, the vector potential calculating unit 13 can calculate the vector potential A using a long time step.

The external magnetic field calculating unit 14 calculates, in accordance with the vector potential A calculated by the vector potential calculating unit 13, the external magnetic field H formed around the magnetic material. For example, the external magnetic field calculating unit 14 obtains the vector potential $A^1$ that is transmitted by the vector potential calculating unit 13. Then, the external magnetic field calculating unit 14 solves Equation (6) using the obtained vector potential $A^1$ so that it calculates the external magnetic field $H^1$. Then, the external magnetic field calculating unit 14 transmits the calculated external magnetic field $H^1$ to the micro-magnetization vector calculating unit 15.

The micro-magnetization vector calculating unit 15 calculates, in accordance with the external magnetic field H calculated by the external magnetic field calculating unit 14, new micro-magnetization vectors m used for the magnetic material. For example, the micro-magnetization vector calculating unit 15 obtains the external magnetic field $H^1$ transmitted by the external magnetic field calculating unit 14. Then, by using the obtained external magnetic field $H^1$, the micro-magnetization vector calculating unit 15 solves Equation (1) for each mesh of the magnetic material so that it calculates new micro-magnetization vectors $m^1$. Then, the micro-magnetization vector calculating unit 15 transmits the calculated micro-magnetization vectors $m^1$ to the output unit 17 and the magnetization vector average value calculating unit 12.

Specifically, using each unit 12 to 15, the analysis apparatus 10 calculates the average value $M^n$ of the micro-magnetization vectors $m^n$ and calculates, from the calculated average value $M^n$, a vector potential $A^{n+1}$ that is made to evolve, to the subsequent time step, over time. Then, the analysis apparatus 10 calculates, from the calculated vector potential $A^{n+1}$, an external magnetic field $H^{n+1}$ and calculates, from the calculated external magnetic field $H^{n+1}$, new micro-magnetization vectors $m^{n+1}$. By repeatedly performing this process, the analysis apparatus 10 can solve the LLG equation and the equation of the magnetic field as both the micro-magnetization vector m and the vector potential A evolve over time.

The magnetic field gradient calculating unit 16 calculates the magnetic field gradient by dividing the increment of the average value M by the increment of the external magnetic field H. For example, the magnetic field gradient calculating unit 16 obtains both the increment $\delta A$ and the vector potential $A^{n+1}$ calculated by the vector potential calculating unit 13. Then, if repeated calculations according to the implicit method are not performed, the magnetic field gradient calculating unit 16 calculates $\Delta H$ using Equation (20) below:

$$\Delta H = \frac{1}{\mu_0} \nabla \times \delta A \tag{20}$$

Furthermore, if repeated calculations according to the implicit method are performed multiple times (for example, n times), the magnetic field gradient calculating unit 16 calculates $\Delta H$ by solving Equation (21) using both the obtained $A^{n+1}$ and the previously obtained $A^n$.

$$\Delta H = \frac{1}{\mu_0} \nabla \times \left( A^{n+1} - A^n \right) \qquad (21)$$

Furthermore, the magnetic field gradient calculating unit 16 calculates, from the previously obtained $A^n$, an external magnetic field $H^n$ and calculates $H^*$ that is the sum of the calculated $H^n$ and $\Delta H$. Furthermore, the magnetic field gradient calculating unit 16 solves Equation (1) and Equation (8) using the calculated $H^*$ and $H^n$ and calculates the average value $M^*$ and the average value $M^n$. Thereafter, the magnetic field gradient calculating unit 16 calculates the difference $\Delta M$ between the calculated average value $M^*$ and the average value $M^n$. Then, the magnetic field gradient calculating unit 16 transmits, to the vector potential calculating unit 13, $\Delta M/\Delta H$ as the magnetic field gradient.

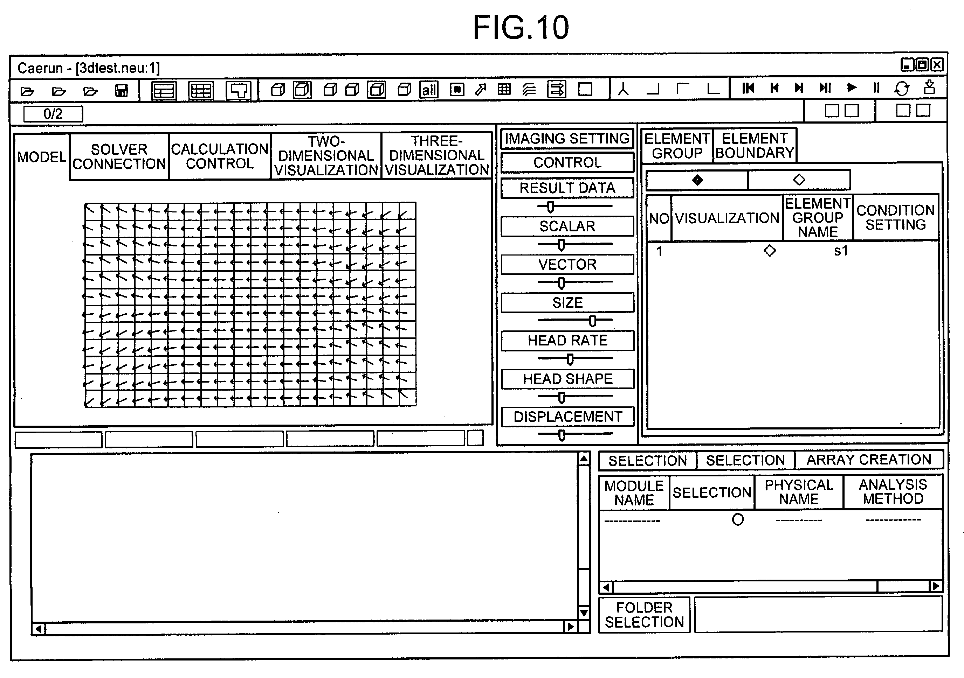

The output unit 17 outputs the new micro-magnetization vectors m calculated by the micro-magnetization vector calculating unit 15. For example, the output unit 17 obtains, from the micro-magnetization vector calculating unit 15, the micro-magnetization vectors $m^1$ to $m^{n+1}$. Then, as illustrated in FIG. 10, the output unit 17 creates, in accordance with the obtained micro-magnetization vectors $m^1$ to $m^{n+1}$, an image in which the properties of the magnetic material are simulated. Then, the output unit 17 displays, on the monitor 6 by using the control unit 4, the created image. FIG. 10 is a schematic diagram illustrating an example of output results.

For example, the control unit 4 and the analysis apparatus 10 are electronic circuits. Furthermore, the receiving unit 11, the magnetization vector average value calculating unit 12, the vector potential calculating unit 13, the external magnetic field calculating unit 14, the micro-magnetization vector calculating unit 15, the magnetic field gradient calculating unit 16, and the output unit 17 are electronic circuits. In the embodiments, examples of the electronic circuit include an integrated circuit, such as an application specific integrated circuit (ASIC) or a field programmable gate array (FPGA), a central processing unit (CPU), and a micro processing unit (MPU).

The memory 2 is a semiconductor memory device, such as a random access memory (RAM), a read only memory (ROM), and a flash memory, or it is a storing unit, such as a hard disc drive and an optical disk.

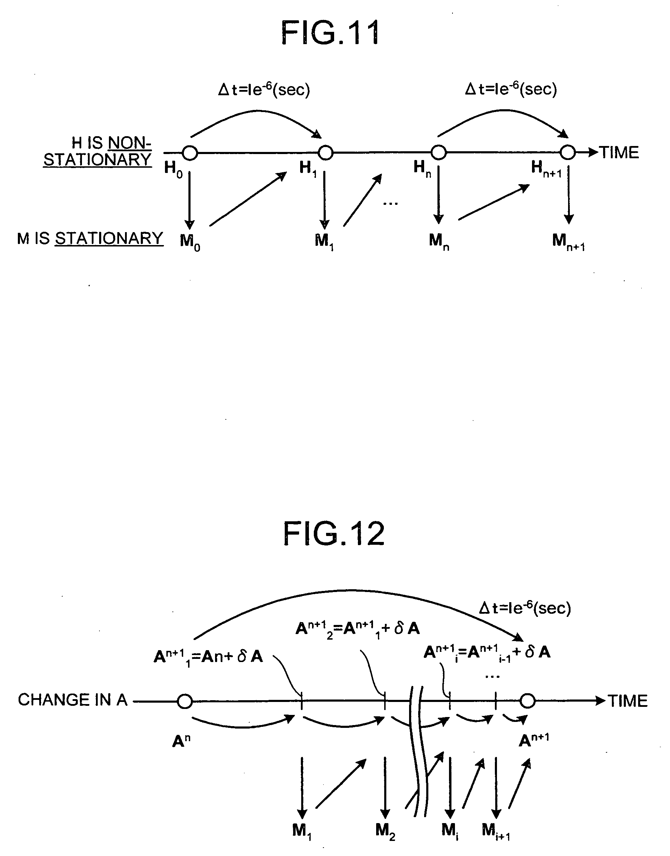

In the following, a process, performed by the analysis apparatus 10, for evolving the external magnetic field H over time by using an explicit expression M will be described with reference to FIG. 11. FIG. 11 is a schematic diagram illustrating an example of a process for evolving time by using the explicit expression M. In the example illustrated in FIG. 11, the analysis apparatus 10 calculates, from a stationary average value $M^0$, a non-stationary external magnetic field $H^1$ obtained after $10^{-6}$ seconds and calculates, from the calculated external magnetic field $H^1$, a stationary average value $M^1$. Accordingly, because the analysis apparatus 10 calculates the external magnetic field H that is made to evolve over time by using the average value M, the analysis apparatus 10 can evolve the time for a longer time scale than the conventional information processing apparatus that calculates a micro-magnetization vector m that is made to evolve over time by using the external magnetic field H.

In the following, a process, performed by the analysis apparatus 10, for evolving the vector potential A over time using an implicit expression M will be described with reference to FIG. 12. FIG. 12 is a schematic diagram illustrating an example of a process for evolving time by using the implicit expression M. In the example illustrated in FIG. 12, the analysis apparatus 10 calculates, using $A^{n+1}_1 = A^n + \delta A$, a stationary state $M_1$ and calculates, from the calculated $M_1$, $A^{n+1}_2 = A^n_1 + \delta A$. By repeatedly performing such calculations until $\delta A$ becomes equal to or less than a predetermined threshold $\varepsilon$, the analysis apparatus 10 can calculate, from $A^n$, $A^{n+1}$ after $10^{-6}$ seconds.

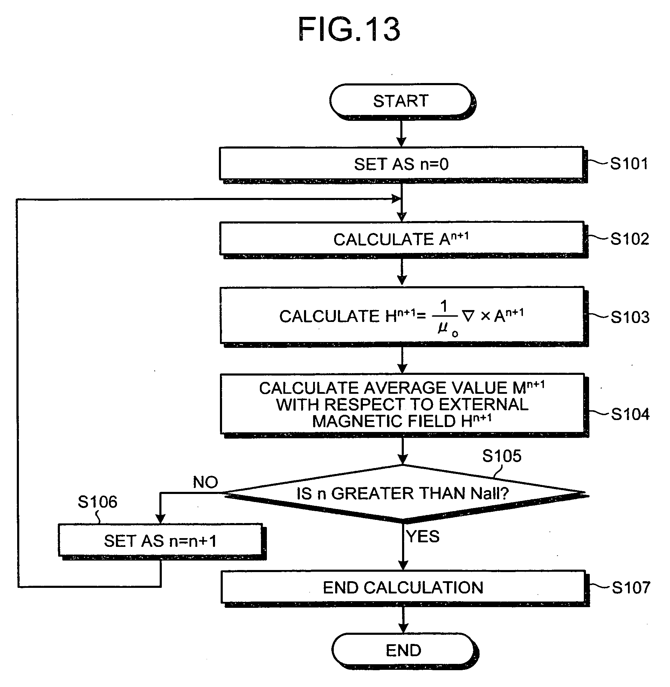

In the following, there will be a description, with reference to FIG. 13, of the flow of a process, performed by the analysis apparatus 10, in which time evolves by using the explicit expression M. FIG. 13 is a flowchart illustrating the flow of a process for evolving time by using the explicit expression M.

First, the analysis apparatus 10 initializes, to "0", n that represents the number of times that time is made to evolve (Step S101). Then, the analysis apparatus 10 solves Equation (10) using an average value $M^n$ and calculates a vector potential $A^{n+1}$ (Step S102). Subsequently, the analysis apparatus 10 solves Equation (6) using the calculated vector potential $A^{n+1}$ and calculates an external magnetic field $H^{n+1}$ (Step S103). Furthermore, the analysis apparatus 10 solves, using the calculated external magnetic field $H^{n+1}$, Equation (1) and Equation (8) and calculates an average value $M^{n+1}$ of the micro-magnetization vectors with respect to the external magnetic field $H^{n+1}$ (Step S104).

Then, the analysis apparatus 10 determines whether the number of times n that time is made to evolve is greater than a predetermined value "Nall" (Step S105). Here, Nall is, for example, the time scale for evolving both the micro-magnetization vector m and the vector potential A over time and is a value divided by the period of time for simulating the properties of the magnetic material set by a user. If the analysis apparatus 10 determines that the number of times n that time is made to evolve is smaller than a predetermined value "Nall" (No at Step S105), the analysis apparatus 10 adds "1" to n (Step S106) and calculates a new vector potential $A^{n+1}$ (Step S102).

In contrast, if the analysis apparatus 10 determines that the number of times n that time is made to evolve is greater than the predetermined value "Nall" (Yes at Step S105), the analysis apparatus 10 ends the calculation (Step S107) and then ends the process.

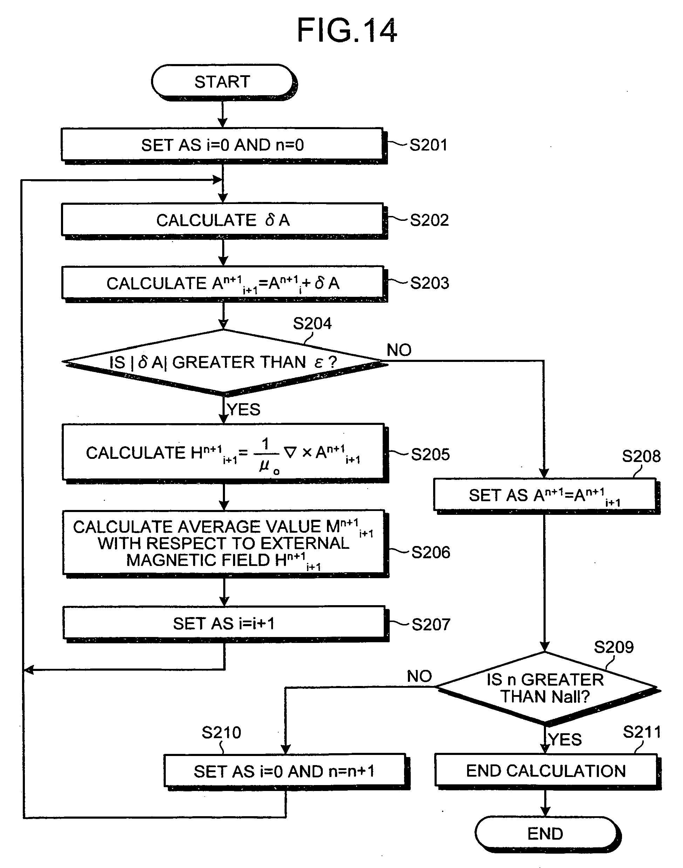

In the following, there will be a description, with reference to FIG. 14, of the flow of a process, performed by the analysis apparatus 10, in which time evolves by using an implicit expression M. FIG. 14 is a flowchart illustrating the flow of a process for evolving time by using the implicit expression M. In the example illustrated in FIG. 14, it is assumed that the analysis apparatus 10 repeatedly performs calculations without using a magnetic field gradient.

First, the analysis apparatus 10 initializes, to "0", both i that is the number of repeated calculations and n that represents the number of times that time is made to evolve (Step S201). Then, the analysis apparatus 10 solves Equation (16) using the average value $M^n$ and calculates $\delta A$ (Step S202). The analysis apparatus 10 then calculates $A^{n+1}{}_{i+1} = A^{n+1}{}_i + \delta A$ (Step S203). Furthermore, the analysis apparatus 10 determines whether the absolute value of $\delta A$ is greater than the predetermined threshold $\varepsilon$ (Step S204).

If the analysis apparatus 10 determines that the absolute value of $\delta A$ is greater than the predetermined threshold $\varepsilon$ (Yes at Step S204), the analysis apparatus 10 solves Equation (6) using $A^{n+1}{}_{i+1}$ and calculates an external magnetic field $H^{n+1}{}_{i+1}$ (Step S205). Then, the analysis apparatus 10 solves, using the external magnetic field $H^{n+1}{}_{i+1}$, Equation (1) and Equation (8) and calculates an average value $M^{n+1}{}_{i+1}$ of the micro-magnetization vectors with respect to the external magnetic field $H^{n+1}{}_{i+1}$ (Step S206). By adding "1" to i (Step S207), the analysis apparatus 10 solves Equation (16) using $M^{n+1}{}_{i+1}$ and again calculates $\delta A$ (Step S202).

In contrast, if the analysis apparatus 10 determines that the absolute value of $\delta A$ is smaller than the predetermined threshold $\varepsilon$ (No at Step S204), the analysis apparatus 10 sets $A^{n+1}{}_{i+1}$ as $A^{n+1}$ (Step S208). Specifically, if the analysis apparatus 10 determines that the absolute value of $\delta A$ is smaller than the predetermined threshold $\varepsilon$, the analysis apparatus 10 sets, as the result of repeated calculations with respect to $\delta$, the calculated $A^{n+1}{}_{i+1}$ as a new vector potential $A^{n+1}$. Then, the analysis apparatus 10 determines whether the number of times n that time is made to evolve is greater than the predetermined value "Nall" (Step S209).

If the analysis apparatus 10 determines that the number of times n that time is made to evolve is smaller than the predetermined value "Nall" (No at Step S209), the analysis apparatus 10 adds "1" to n and initializes i to "0" (Step S210). Thereafter, the analysis apparatus 10 again calculates $\delta A$ (Step S202). Furthermore, if the analysis apparatus 10 determines that the number of times n that time is made to evolve is greater than the predetermined value "Nall" (Yes at Step S209), the analysis apparatus 10 ends the calculation (Step S211) and then ends the process.

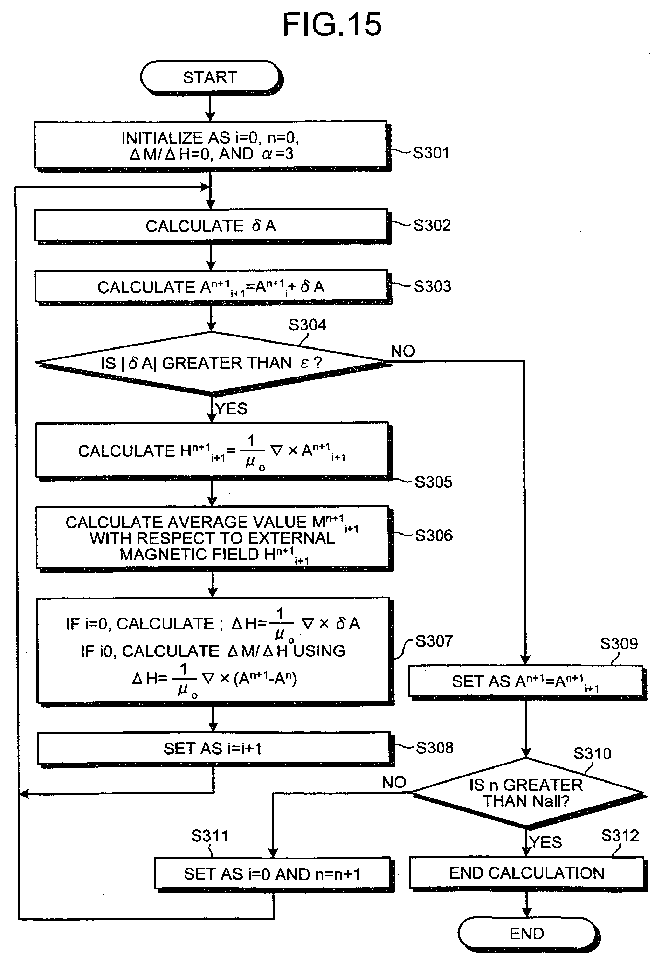

In the following, there will be a description, with reference to FIG. 15, of a process, performed by the analysis apparatus 10, in which time evolves by using both the magnetic field gradient and the implicit expression M. FIG. 15 is a flowchart illustrating the flow of a process, in which time evolves, using a magnetic field gradient. In the process illustrated in FIG. 15, Steps S302 to S306 and S308 are the same as Steps S202 to S206 and S207 illustrated in FIG. 14; therefore, descriptions thereof will be omitted. Furthermore, Steps S309 to S312 are the same as Steps S208 to S211 illustrated in FIG. 14; therefore, descriptions thereof will be omitted.

First, the analysis apparatus 10 initializes i, which is the number of repeated calculations, to "0"; initializes n, which represents the number of times that time is made to evolve, to "0"; and initializes $\Delta M/\Delta H$, which is the magnetic field gradient, to "0"; and initializes the predetermined coefficient $\alpha$ to "3" (Step S301). Furthermore, if i is "0", the analysis apparatus 10 calculates $\Delta H$ using Equation (20), whereas if i is not "0", the analysis apparatus 10 calculates $\Delta H$ using Equation (21). Then, the analysis apparatus 10 calculates the magnetic field gradient $\Delta M/\Delta H$ using the calculated $\Delta H$ (Step S307).

Advantage of First Embodiment

As described above, the information processing apparatus 1 according to the first embodiment calculates an average value $M^n$ of a plurality of micro-magnetization vectors m allocated to the magnetic material that corresponds to the object to be analyzed. Then, by using the calculated average value $M^n$ and the equation of the magnetic field that is the governing equation of the vector potential, the information processing apparatus 1 calculates a vector potential $A^{n+1}$ at the subsequent time step. Accordingly, the information processing apparatus 1 can evolve both the LLG equation and the equation of the magnetic field over time for a long time scale, thus simulating the properties of the magnetic material over a long period of time.

Furthermore, by using Equation (10) that explicitly represents the average value M of the magnetization vectors that is derived from both LLG Equation (1) and from Equation (7) of the magnetic field and by using the average value $M^n$ of the magnetization vector, the information processing apparatus 1 calculates a vector potential $A^{n+1}$ obtained after a predetermined time has elapsed. Accordingly, the information processing apparatus 1 can calculate, in a single calculation, the vector potential $A^{n+1}$ at the subsequent time step. As a result, because the information processing apparatus 1 reduces the amount of calculation in which both the LLG equation and the equation of the magnetic field are made to evolve over time, the information processing apparatus 1 can simulate the properties of the magnetic material over a further longer period of time.

Furthermore, by using Equation (13) that implicitly represents the average value M of the magnetization vectors derived from LLG Equation (1) and from Equation (7) of the magnetic field and by using the average value $M^n$ of the

micro-magnetization vectors, the information processing apparatus 1 calculates the increment $\delta A$ of the vector potential. Then, in accordance with the calculated increment $\delta A$ of the vector potential, the information processing apparatus 1 calculates the vector potential $A^{n+1}$ at the subsequent time step. Accordingly, even when the implicit method is used, the information processing apparatus 1 can evolve the LLG equation and the equation of the magnetic field over time for a long time scale. As a result, it is possible to accurately simulate the properties of the magnetic material for a long period of time.

Furthermore, during the process for evolving time from $A^n$ to $A^{n+1}$, when repeatedly performing calculations according to the implicit method, the information processing apparatus 1 calculates, from the average value $M^n_i$ of the micro-magnetization vectors, the increment $\delta A$ of the vector potential. Then, the information processing apparatus 1 calculates, in accordance with the calculated increment $\delta A$ of the vector potential, a new vector potential $A^{n+1}_{i+1}$.

Specifically, in the repeated calculations of the vector potential from $A^n$ to $A^{n+1}$, the information processing apparatus 1 calculates, from the vector potential $A^{n+1}_0$, $A^{n+1}_{i+1}$ by assuming each of the average values $M^n_0$ to $M^n_{i+1}$ of the micro-magnetization vectors to be stationary. Accordingly, in each Step of the repeated calculations according to the implicit method, the information processing apparatus 1 can evolve both the LLG equation and the equation of the magnetic field for a longer time scale, thus further extending the period of time for simulating the properties of the magnetic material.

Furthermore, the information processing apparatus 1 speeds up, using the magnetic field gradient $\Delta M/\Delta H$, the convergence of $\delta A$ in the repeated calculations. Accordingly, the information processing apparatus 1 can reduce the number of repeated calculations according to the implicit method; therefore, it is possible for the information processing apparatus 1 to reduce the amount of calculation and to further extend the period of time for simulating the properties of the magnetic material.

Furthermore, if the sum of a predetermined coefficient $\alpha$ and $\delta H$, where $\delta H$ is obtained by dividing the saturation magnetic field $H_{sat}$ by the number of micro-magnetization vectors m allocated to the magnetic material, is greater than the increment $\Delta H$ of the external magnetic field, the information processing apparatus 1 performs a calculation using the magnetic field gradient $\Delta M/\Delta H$. Specifically, if the sum of $\delta H$ and $\alpha$ is greater than the increment AH of the external magnetic field, irregularities produced on the M-H curve are large; therefore, the gradient of the average values M is not accurate. Accordingly, if the sum of $\delta H$ and the predetermined coefficient $\alpha$ is smaller than the increment AH of the external magnetic field, the information processing apparatus 1 can use the appropriate magnetic field gradient $\Delta M/\Delta H$. As a result, the information processing apparatus 1 can appropriately speed up the convergence of $\delta A$ in the repeated calculations.

[b] Second Embodiment

The embodiments of the present invention have been described; however, the present invention is not limited to the embodiments described above and can be implemented with various kinds of embodiments other than the embodiments described above. Accordingly, another embodiment included in the present invention will be described as a second embodiment.

(1) Predetermined coefficient $\alpha$

If the sum of $\delta H$ and the predetermined coefficient $\alpha$ is smaller than $\Delta H$, the analysis apparatus 10 according to the first embodiment described above estimates that the irregularities on the M-H curves are within the variation of $\Delta H$. When evolving time using the magnetic field gradient and the implicit expression M, the analysis apparatus 10 initializes a predetermined coefficient $\alpha$ to "3"; however, the embodiment is not limited thereto. The predetermined coefficient $\alpha$ can be another value. For example, predetermined coefficient $\alpha$ can be a value that can appropriately be changed in accordance with the properties of the magnetic material that is the object to be analyzed or changed in accordance with the number of micro-magnetization vectors m allocated to the magnetic material.

(2) Time scale over which time evolves

The analysis apparatus 10 according to the first embodiment described above evolves both the LLG equation and the equation of the magnetic field over time at time intervals of $10^{-6}$ ; however, the embodiment is not limited thereto. Any given time step can be used so long as the vector potential A can be accurately calculated at the subsequent time step. Furthermore, for example, the time scale of the time step can be changed for each calculation. For example, the analysis apparatus 10 can evolve both the LLG equation and the equation of the magnetic field over time for a given time scale between approximately $10^{-6}$ and $10^{-12}$ seconds.

(3) Information processing apparatus

The information processing apparatus 1 according to the first embodiment has a single analysis apparatus 10; however, the embodiment is not limited thereto. For example, an information processing apparatus 1a according to the second embodiment has a plurality of analysis apparatuses 10A to 10Z that have the same function as that performed by the analysis apparatus 10. If the size of the magnetic material that is the object to be analyzed is large, the information processing apparatus 1a divides the magnetic material into regions A to Z and allows the analysis apparatuses 10A to 10Z to perform a parallel calculation of the properties of each of the divided regions A to Z.

Calculating the average value M from the micro-magnetization vectors m can be independently performed for each of the regions A to Z. Accordingly, the information processing apparatus 1a can accurately calculate, in a short period of time, the properties of the magnetic material that is the object to be analyzed over a long period of time.

(4) Program

With the analysis apparatus 10 according to the first embodiment, a case in which various processes are implemented using hardware has been described; however, the embodiments are not limited thereto. For example, it is possible to implement an analysis program prepared in advance and executed by a computer. Accordingly, in the following, a computer that executes the analysis program having the same functions as those performed by the analysis apparatus 10 described in the first embodiment will be described as an example with reference to FIG. 16. FIG. 16 is a functional block diagram illustrating a computer that executes the analysis program.

In a computer 100 illustrated in FIG. 16 , a random access memory (RAM) 120, a read only memory (ROM) 130, and a hard disk drive (HDD) 150 are connected via a bus 170. Furthermore, in the computer 100 illustrated in FIG. 16, a central processing unit (CPU) 140 is connected via the bus 170. Furthermore, an input/output (I/O) 160 that receives an input from a user is connected to the bus 170.

The ROM 130 stores therein, in advance, a receiving program 131 and a vector potential calculating program 132. In the example illustrated in FIG. 16, the CPU 140 reads each of the programs 131 and 132 from the ROM 130 and executes them so that the programs 131 and 132 functions as a receiving process 141 and a vector potential calculating process 142, respectively. Furthermore, each of the processes 141 and 142 has the same function, respectively, as that performed by the units 11 and 12 illustrated in FIG. 1. Each of the processes 141 and 142 can also have the same function as that performed by each unit according to the second or third embodiment.

The analysis program in the embodiments can be implemented by a program prepared in advance and executed by a computer, such as a personal computer or a workstation. The program can be sent using a network such as the Internet. Furthermore, the program can be stored in a computer-readable recording medium, such as a hard disc drive, a flexible disk (FD), a compact disc read only memory (CD-ROM), a magneto optical disc (MO), and a digital versatile disc (DVD). Furthermore, the program can also be implemented by the computer reading it from the recording medium.

According to an embodiment, it is advantageously possible to simulate the properties of magnetic materials for a long period of time.

**Claims**

1. An analysis apparatus (10) comprising:

   a receiving unit (11) that receives a property information on an object to be analyzed; and
   a vector potential calculating unit (12, 13, 15) that calculates an average value of a plurality of magnetization vectors allocated to each region of the object that is obtained by dividing the object to be analyzed in accordance with the received property information of the object to be analyzed, and calculates a vector potential obtained after a predetermined time has elapsed by using the calculated average value of the magnetization vectors and an equation of a magnetic field that is a governing equation of a vector potential,

   **characterized in that**:

   the vector potential calculating unit (12, 13, 15) calculates the vector potential obtained after the predetermined time has elapsed by using the calculated average value of the magnetization vectors and an equation that explicitly represents the average value of the magnetization vectors that is derived from an equation of motion that represents a change in a magnetization vector and the equation of the magnetic field.

2. The analysis apparatus (10) according to claim 1, wherein the vector potential calculating unit (12, 13, 15) calculates an increment of a vector potential by using the calculated average value of the magnetization vectors, an equation that implicitly represents the average value of the magnetization vectors and that is derived from an equation of motion that represents a change in a magnetization vector and the equation of the magnetic field, and calculates the vector potential obtained after the predetermined time has elapsed in accordance with the calculated increment of the vector potential.

3. The analysis apparatus (10) according to claim 2, wherein
   the vector potential calculating unit (12, 13, 15) repeatedly performs a series of calculations, in which a new vector potential is calculated in accordance with the increment of the vector potential, a new average value of magnetization vectors is calculated by using the calculated new vector potential, and a new increment of a vector potential is calculated by using the calculated new average value of the magnetization vectors and the equation that implicitly represents the calculated average value of the magnetization vectors, the series of calculations being repeatedly performed until the new increment of the vector potential becomes equal to or less than a predetermined threshold, and
   the vector potential calculating unit (12, 13, 15) sets a new vector potential which is calculated in an immediately previous calculation in the calculations repeatedly performed as the vector potential obtained after the predetermined time has elapsed when the new increment of the vector potential becomes equal to or less than the predetermined threshold.

4. The analysis apparatus (10) according to claim 2 or 3, further comprising a magnetic field gradient calculating unit (16) that calculates a magnetic field gradient by dividing an increment of the calculated average value of the magnetization vectors by an increment of a magnetic field formed around the object to be analyzed, wherein
   the vector potential calculating unit (12, 13, 15) calculates the increment of the vector potential by using the equation that implicitly represents the calculated average value of the magnetization vectors, the calculated average value of the magnetization vectors, and the calculated magnetic field gradient.

5. The analysis apparatus (10) according to claim 4, wherein
   the vector potential calculating unit (12, 13, 15) calculates the increment of the vector potential when a sum of a predetermined coefficient and a value obtained by dividing a saturation magnetic field of the object to be analyzed by the number of magnetization vectors allocated to the object to be analyzed is smaller than the increment of the magnetic field, by using the equation that implicitly represents the calculated average value of the magnetization vectors, the calculated average value of the magnetization vectors, and the magnetic field gradient, and
   the vector potential calculating unit (12, 13, 15) calculates when the sum of the predetermined coefficient and a value obtained by dividing the saturation magnetic field of the object to be analyzed by the number of magnetization vectors is greater than the increment of the magnetic field, by using the equation that implicitly represents the calculated average value of the magnetization vectors, the calculated average value of the magnetization vector, and the increment of the vector potential.

6. An analysis method executed on an apparatus, the method comprising:

   calculating an average value of a plurality of magnetization vectors allocated to each region of the object that is obtained by dividing the object to be analyzed; and
   calculating a vector potential obtained after a predetermined time has elapsed by using the calculated average value of the magnetization vectors and an equation of a magnetic field that is a governing equation of a vector potential,

   **characterized by**:

   calculating the vector potential obtained after the predetermined time has elapsed by using the calculated average value of the magnetization vectors and an equation that explicitly represents the average value of the magnetization vectors that is derived from an equation of motion that represents a change in a magnetization vector and the equation of the magnetic field.

7. An analysis program configured to cause a computer to execute a process, the process comprising:

   calculating an average value of magnetization vectors allocated to each region that is obtained by dividing the object to be analyzed; and
   calculating a vector potential obtained after a predetermined time has elapsed by using the calculated average value of the magnetization vectors and an equation of a magnetic field that is a governing equation of a vector potential, **characterized in that** the process comprises:

calculating the vector potential obtained after the predetermined time has elapsed by using the calculated average value of the magnetization vectors and an equation that explicitly represents the average value of the magnetization vectors that is derived from an equation of motion that represents a change in a magnetization vector and the equation of the magnetic field.

**8.** A computer-readable medium storing the analysis program according to claim 7, wherein the medium is optionally a non-transitory medium.


**Patentansprüche**

**1.** Analysevorrichtung (10), umfassend:

eine Empfangseinheit (11), die Eigenschaftsinformationen über ein zu analysierendes Objekt empfängt; und eine Vektorpotentialberechnungseinheit (12, 13, 15), die einen Durchschnittswert einer Vielzahl von Magnetisierungsvektoren berechnet, die jeder Region des Objektes zugeordnet sind, die erhalten wird, indem das zu analysierende Objekt gemäß den empfangenen Eigenschaftsinformationen des zu analysierenden Objektes geteilt wird, und ein Vektorpotential berechnet, das nach Ablauf einer vorbestimmten Zeit erhalten wird, unter Verwendung des berechneten Durchschnittswertes der Magnetisierungsvektoren und einer Gleichung eines Magnetfeldes, die eine Grundgleichung eines Vektorpotentials ist,

**dadurch gekennzeichnet, dass**:

die Vektorpotentialberechnungseinheit (12, 13, 15) das Vektorpotential berechnet, das nach Ablauf der vorbestimmten Zeit erhalten wird, unter Verwendung des berechneten Durchschnittswertes der Magnetisierungsvektoren und einer Gleichung, die den Durchschnittswert der Magnetisierungsvektoren explizit darstellt und die von einer Bewegungsgleichung abgeleitet wird, die eine Veränderung eines Magnetisierungsvektors darstellt, und der Gleichung des Magnetfeldes.

**2.** Analysevorrichtung (10) nach Anspruch 1, bei der die Vektorpotentialberechnungseinheit (12, 13, 15) ein Inkrement eines Vektorpotentials berechnet, unter Verwendung des berechneten Durchschnittswertes der Magnetisierungsvektoren, einer Gleichung, die den Durchschnittswert der Magnetisierungsvektoren implizit darstellt und die von einer Bewegungsgleichung abgeleitet wird, die eine Veränderung eines Magnetisierungsvektors darstellt, und der Gleichung des Magnetfeldes, und das Vektorpotential, das nach Ablauf der vorbestimmten Zeit erhalten wird, gemäß dem berechneten Inkrement des Vektorpotentials berechnet.

**3.** Analysevorrichtung (10) nach Anspruch 2, bei der die Vektorpotentialberechnungseinheit (12, 13, 15) eine Reihe von Berechnungen wiederholt ausführt, bei denen ein neues Vektorpotential gemäß dem Inkrement des Vektorpotentials berechnet wird, ein neuer Durchschnittswert von Magnetisierungsvektoren unter Verwendung des berechneten neuen Vektorpotentials berechnet wird und ein neues Inkrement eines Vektorpotentials unter Verwendung des berechneten neuen Durchschnittswertes der Magnetisierungsvektoren und der Gleichung berechnet wird, die den berechneten Durchschnittswert der Magnetisierungsvektoren implizit darstellt, welche Reihe von Berechnungen wiederholt ausgeführt wird, bis das neue Inkrement des Vektorpotentials kleiner gleich einer vorbestimmten Schwelle wird, und die Vektorpotentialberechnungseinheit (12, 13, 15) ein neues Vektorpotential, das bei einer unmittelbar vorausgehenden Berechnung bei den wiederholt ausgeführten Berechnungen berechnet wird, als das Vektorpotential einstellt, das nach Ablauf der vorbestimmten Zeit erhalten wird, wenn das neue Inkrement des Vektorpotentials kleiner gleich der vorbestimmten Schwelle wird.

**4.** Analysevorrichtung (10) nach Anspruch 2 oder 3, die ferner eine Magnetfeldgradientenberechnungseinheit (16) umfasst, die einen Magnetfeldgradienten durch Teilen eines Inkrements des berechneten Durchschnittswertes der Magnetisierungsvektoren durch ein Inkrement eines um das zu analysierende Objekt gebildeten Magnetfeldes berechnet, bei der die Vektorpotentialberechnungseinheit (12, 13, 15) das Inkrement des Vektorpotentials unter Verwendung der Gleichung, die den berechneten Durchschnittswert der Magnetisierungsvektoren implizit darstellt, des berechneten Durchschnittswertes der Magnetisierungsvektoren und des berechneten Magnetfeldgradienten berechnet.

5. Analysevorrichtung (10) nach Anspruch 4, bei der die Vektorpotentialberechnungseinheit (12, 13, 15) das Inkrement des Vektorpotentials dann, wenn eine Summe eines vorbestimmten Koeffizienten und eines Wertes, der durch Teilen eines Sättigungsmagnetfeldes des zu analysierenden Objektes durch die Anzahl von Magnetisierungsvektoren erhalten wird, die dem zu analysierenden Objekt zugeordnet sind, kleiner als das Inkrement des Magnetfeldes ist, unter Verwendung der Gleichung berechnet, die den berechneten Durchschnittswert der Magnetisierungsvektoren implizit darstellt, des berechneten Durchschnittswertes der Magnetisierungsvektoren und des Magnetfeldgradienten, und

die Vektorpotentialberechnungseinheit (12, 13, 15) dann, wenn die Summe des vorbestimmten Koeffizienten und eines Wertes, der durch Teilen des Sättigungsmagnetfeldes des zu analysierenden Objektes durch die Anzahl von Magnetisierungsvektoren erhalten wird, größer als das Inkrement des Magnetfeldes ist, unter Verwendung der Gleichung berechnet, die den berechneten Durchschnittswert der Magnetisierungsvektoren implizit darstellt, des berechneten Durchschnittswertes des Magnetisierungsvektors und des Inkrements des Vektorpotentials.

6. Analyseverfahren, das auf einer Vorrichtung ausgeführt wird, welches Verfahren umfasst:

Berechnen eines Durchschnittswertes einer Vielzahl von Magnetisierungsvektoren, die jeder Region des Objektes zugeordnet sind, die erhalten wird, indem das Objekt, das zu analysieren ist, geteilt wird; und
Berechnen eines Vektorpotentials, das nach Ablauf einer vorbestimmten Zeit erhalten wird, unter Verwendung des berechneten Durchschnittswertes der Magnetisierungsvektoren und einer Gleichung eines Magnetfeldes, die eine Grundgleichung eines Vektorpotentials ist,

**gekennzeichnet durch**:

Berechnen des Vektorpotentials, das nach Ablauf der vorbestimmten Zeit erhalten wird, unter Verwendung des berechneten Durchschnittswertes der Magnetisierungsvektoren und einer Gleichung, die den Durchschnittswert der Magnetisierungsvektoren explizit darstellt und die von einer Bewegungsgleichung abgeleitet wird, die eine Veränderung eines Magnetisierungsvektors darstellt, und der Gleichung des Magnetfeldes.

7. Analyseprogramm, das konfiguriert ist, um zu bewirken, dass ein Computer einen Prozess ausführt, welcher Prozess umfasst:

Berechnen eines Durchschnittswertes von Magnetisierungsvektoren, die jeder Region zugeordnet sind, die erhalten wird, indem das Objekt, das zu analysieren ist, geteilt wird; und
Berechnen eines Vektorpotentials, das nach Ablauf einer vorbestimmten Zeit erhalten wird, unter Verwendung des berechneten Durchschnittswertes der Magnetisierungsvektoren und einer Gleichung eines Magnetfeldes, die eine Grundgleichung eines Vektorpotentials ist, **dadurch gekennzeichnet, dass** der Prozess umfasst:

Berechnen des Vektorpotentials, das nach Ablauf der vorbestimmten Zeit erhalten wird, unter Verwendung des berechneten Durchschnittswertes der Magnetisierungsvektoren und einer Gleichung, die den Durchschnittswert der Magnetisierungsvektoren explizit darstellt und die von einer Bewegungsgleichung abgeleitet wird, die eine Veränderung eines Magnetisierungsvektors darstellt, und der Gleichung des Magnetfeldes.

8. Computerlesbares Medium, welches das Analyseprogramm nach Anspruch 7 speichert, welches Medium optional ein nichttransitorisches Medium ist.


**Revendications**

1. Appareil d'analyse (10) comprenant :

une unité réceptrice (11) qui reçoit des informations de propriété concernant un objet à analyser ; et
une unité de calcul de potentiel vecteur (12, 13, 15) qui calcule une valeur moyenne d'une pluralité de vecteurs de magnétisation alloués à chaque région de l'objet, qui est obtenue par le fait de diviser l'objet à analyser selon les informations de propriété reçues concernant l'objet à analyser, et calcule un potentiel vecteur obtenu après écoulement d'un laps de temps prédéterminé à l'aide de la valeur moyenne calculée des vecteurs de magnétisation et d'une équation d'un champ magnétique qui est une équation régissant un potentiel vecteur,

**caractérisé en ce que** :

l'unité de calcul de potentiel vecteur (12, 13, 15) calcule le potentiel vecteur obtenu après écoulement du laps de temps prédéterminé à l'aide de la valeur moyenne calculée des vecteurs de magnétisation et d'une équation qui représente explicitement la valeur moyenne des vecteurs de magnétisation qui est déduite d'une équation de mouvement qui représente un changement d'un vecteur de magnétisation et de l'équation du champ magnétique.

2. Appareil d'analyse (10) selon la revendication 1, dans lequel l'unité de calcul de potentiel vecteur (12, 13, 15) calcule un incrément d'un potentiel vecteur à l'aide de la valeur moyenne calculée des vecteurs de magnétisation, d'une équation qui représente implicitement la valeur moyenne des vecteurs de magnétisation et qui est déduite d'une équation de mouvement qui représente un changement d'un vecteur de magnétisation et de l'équation du champ magnétique, et calcule le potentiel vecteur obtenu après écoulement du laps de temps prédéterminé selon l'incrément calculé pour le potentiel vecteur.

3. Appareil d'analyse (10) selon la revendication 2, dans lequel l'unité de calcul de potentiel vecteur (12, 13, 15) exécute de manière répétitive une série de calculs, dans laquelle un nouveau potentiel vecteur est calculé selon l'incrément du potentiel vecteur, une nouvelle valeur moyenne des vecteurs de magnétisation est calculée à l'aide du nouveau potentiel vecteur calculé, et un nouvel incrément d'un potentiel vecteur est calculé à l'aide de la nouvelle valeur moyenne calculée des vecteurs de magnétisation et de l'équation qui représente implicitement la valeur moyenne calculée des vecteurs de magnétisation, la série de calculs étant exécutée de manière répétitive jusqu'à ce que le nouvel incrément du potentiel vecteur devienne égal ou inférieur à un seuil prédéterminé, et l'unité de calcul de potentiel vecteur (12, 13, 15) définit un nouveau potentiel vecteur, qui est calculé dans un calcul immédiatement précédent dans les calculs exécutés de manière répétitive, en tant que potentiel vecteur obtenu après écoulement du laps de temps prédéterminé quand le nouvel incrément du potentiel vecteur devient égal ou inférieur au seuil prédéterminé.

4. Appareil d'analyse (10) selon la revendication 2 ou 3, comprenant en outre une unité de calcul de gradient de champ magnétique (16) qui calcule un gradient de champ magnétique par le fait de diviser un incrément de la valeur moyenne calculée des vecteurs de magnétisation par un incrément d'un champ magnétique formé autour de l'objet à analyser, dans lequel l'unité de calcul de potentiel vecteur (12, 13, 15) calcule l'incrément du potentiel vecteur à l'aide de l'équation qui représente implicitement la valeur moyenne calculée des vecteurs de magnétisation, de la valeur moyenne calculée des vecteurs de magnétisation, et du gradient de champ magnétique calculé.

5. Appareil d'analyse (10) selon la revendication 4, dans lequel l'unité de calcul de potentiel vecteur (12, 13, 15) calcule l'incrément du potentiel vecteur quand une somme d'un coefficient prédéterminé et d'une valeur obtenue par le fait de diviser un champ magnétique de saturation de l'objet à analyser par le nombre de vecteurs de magnétisation alloués à l'objet à analyser est inférieur à l'incrément du champ magnétique, à l'aide de l'équation qui représente implicitement la valeur moyenne calculée des vecteurs de magnétisation, de la valeur moyenne calculée des vecteurs de magnétisation, et du gradient de champ magnétique, et l'unité de calcul de potentiel vecteur (12, 13, 15) calcule quand la somme du coefficient prédéterminé et d'une valeur obtenue par le fait de diviser le champ magnétique de saturation de l'objet à analyser par le nombre de vecteurs de magnétisation est supérieur à l'incrément du champ magnétique, à l'aide de l'équation qui représente implicitement la valeur moyenne calculée des vecteurs de magnétisation, de la valeur moyenne calculée des vecteurs de magnétisation, et de l'incrément du potentiel vecteur.

6. Procédé d'analyse exécuté sur un appareil, le procédé comprenant les étapes de :

calcul d'une valeur moyenne d'une pluralité de vecteurs de magnétisation alloués à chaque région de l'objet, qui est obtenue par le fait de diviser l'objet à analyser ; et

calcul d'un potentiel vecteur obtenu après écoulement d'un laps de temps prédéterminé, à l'aide de la valeur moyenne calculée des vecteurs de magnétisation et d'une équation d'un champ magnétique qui est une équation régissant un potentiel vecteur,

**caractérisé par** l'étape de :

calcul du potentiel vecteur obtenu après écoulement du laps de temps prédéterminé, à l'aide de la valeur moyenne calculée des vecteurs de magnétisation et d'une équation qui représente explicitement la valeur moyenne des vecteurs de magnétisation qui est déduite d'une équation de mouvement qui représente un changement d'un vecteur de magnétisation et de l'équation du champ magnétique.

7. Programme d'analyse configuré pour faire exécuter un procédé à un ordinateur, le procédé comprenant les étapes de :

calcul d'une valeur moyenne de vecteurs de magnétisation alloués à chaque région, qui est obtenue par le fait de diviser l'objet à analyser ; et
calcul d'un potentiel vecteur obtenu après écoulement d'un laps de temps prédéterminé, à l'aide de la valeur moyenne calculée des vecteurs de magnétisation et d'une équation d'un champ magnétique qui est une équation régissant un potentiel vecteur,

**caractérisé en ce que** le procédé comprend l'étape de :

calcul du potentiel vecteur obtenu après écoulement du laps de temps prédéterminé, à l'aide de la valeur moyenne calculée des vecteurs de magnétisation et d'une équation qui représente explicitement la valeur moyenne des vecteurs de magnétisation qui est déduite d'une équation de mouvement qui représente un changement d'un vecteur de magnétisation et de l'équation du champ magnétique.

8. Support lisible par un ordinateur stockant le programme d'analyse selon la revendication 7, lequel support étant optionnellement un support non transitoire.

# FIG.1

INFORMATION PROCESSING APPARATUS 1

MEMORY 2

HDD 3

CONTROL UNIT 4

KEYBOARD 5

MONITOR 6

ANALYSIS APPARATUS 10

RECEIVING UNIT 11

MAGNETIZATION VECTOR AVERAGE VALUE CALCULATING UNIT 12

VECTOR POTENTIAL CALCULATING UNIT 13

EXTERNAL MAGNETIC FIELD CALCULATING UNIT 14

MICRO-MAGNETIZATION VECTOR CALCULATING UNIT 15

MAGNETIC FIELD GRADIENT CALCULATING UNIT 16

OUTPUT UNIT 17

# FIG.2

EP 2 420 853 B1

# FIG.3

## BASIC CALCULATION

- CURRENT CALCULATION
- CURRENT MAGNETIC FIELD CALCULATION
- **MICRO-MAGNETIZATION CALCULATION**
- STATIC MAGNETIC FIELD CALCULATION VERIFICATION

## STATIC MAGNETIC FIELD CALCULATING METHOD

- FE-BI (NODE SCALAR)
- FE-BI (NODE VECTOR)
- FEM (NODE VECTOR)
- FEM (SIDE VECTOR)
- MAGNETIC CHARGE SUPERPOSITION

## CALCULATING METHOD AND OPTION

| STATIONARY | NON STATIONARY |

☐ EXTERNAL MAGNETIC FIELD CONTROL (STATIONARY)
☐ EXTERNAL MAGNETIC FIELD CONTROL (NON-TATIONARY)
☐ COIL CURRENT CONTROL (NON-STATIONARY)

## MODEL SCALE

SIZE UNIT [nm ▼]

SCALE MAGNIFICATION [1.000E+00]

---

COMMENT | INPUT APPROPRIATE COMMENT

| TIME INTEGRATION | CONTROL EXTERNAL MAGNETIC FIELD (STATIONARY) | CONTROL EXTERNAL MAGNETIC FIELD (NON-STATIONARY) | CONTROL CURRENT | MOBILITY MODEL/ OTHERS | SAVE DATA |

### TIME INTEGRATION METHOD

- BDF
- Adams
- EULER
- RUNGE-KUTTA

### TIME INTEGRATION PARAMETER

TIME INTERVAL (SEC) [2.000E-12]

NUMBER OF STEPS [5000]

CALCULATION TIME (SEC) [1.000E-08]

[ CALCULATE ]

### START IN MIDDLE OF CALCULATION

[ INITIAL VALUE OF RESULT DATA ]

INITIAL STEP [0] [◄][►]

SAVING METHOD
◉ SAVE FROM INITIAL STEP
○ SAVE ALL

### CONVERGENCE CRITERION

CONVERGENCE THRESHOLD OF LLG EQUATION [1.000E-07]

CONVERGENCE THRESHOLD OF CURRENT CALCULATION [1.000E-08]

CONVERGENCE THRESHOLD OF MAGNETIC FIELD CALCULATION [1.000E-07]

NUMBER OF MAXIMUM ITERATIONS [10000000]

CONVERGENCE CRITERION METHOD | AVERAGE MAGNETIZATION | MAXIMUM MAGNETIZATION |

CALCULATION COMPLETION METHOD | UNTIL CONVERGENCE | NUMBER OF STEPS |

### CVODE PARAMETER

ABSOLUTE ERROR [1.000E-06]

RELATIVE ERROR [1.000E-03]

INTERPOLATION ORDER [5] [◄][►]

CORRECTION COEFFICIENT 1 [1.000E+00]

CORRECTION COEFFICIENT 2 [1.000E+00]

☐ PREPROCESSING

STEP PROCESSING METHOD

[CV_NORMAL ▼]

---

[ OK ]  [ CANCEL ]  [ READ FREE LAYER DATA ] [ READ GAMBIT RESULT DATA ]

# FIG.4

EP 2 420 853 B1

**CONDITION FOR GROUP SETTING** ☒

ID= 1    NAME= s1

**BASIC PROPERTY VALUE**
PERMEABILITY  1.000E+00

**CONDUCTIVE PROPERTY VALUE**
CONDUCTIVITY  1.000E+00  | EXCITATION CURRENT | EDDY CURRENTS |

**MOBILITY ELEMENT**
STATIC

**SAVE MAGNETIC FIELD**
NOT SAVE

**MATERIAL PROPERTY**
| NO SETTING | AIR | CONDUCTOR | MICRO MAGNETIZATION | CONNECTING ELEMENT | MAGNETIC MATERIAL |

**BASIC MATERIAL CHARACTERISTICS**
MAGNETIZATION INTENSITY (T)  1.000E+00
SWITCHED CONNECTION COEFFICIENT (J/M)  1.000E-11
FRICTION COEFFICIENT  1.000E+00

**ANISOTROPY SETTINGS**
ANISOTROPIC MAGNETIC FIELD (Oe)  0.000E+00
| ALIGNMENT | RANDOM |
RANDOM TYPE
| THREE DIMENSION | TWO DIMENSION |
ALIGNMENT DIRECTION
X COMPONENT  1.000E+00
Y COMPONENT  0.000E+00
Z COMPONENT  0.000E+00

**INITIAL MAGNETIZATION VECTOR**
INITIAL X COMPONENT  1.000E+00
INITIAL Y COMPONENT  0.000E+00
INITIAL Z COMPONENT  0.000E+00
USE READ DATA

**SETTINGS OF LEAD ANALYSIS**
MAGNETIC MEMBRANE PROPERTY
NO SETTINGS ▼
MODELLING CRYSTAL
☐ CONSIDER ORIENTATION ON BASE SURFACE
☐ INITIAL VECTOR IS IN DIRECTION OF EASY AXIS
WEAKEN CRYSTAL INTERFACE
WEAKEN COEFFICIENT  1.000E+00

**SETTINGS OF INTERNAL MAGNETIC FIELD**
CONSIDER INTERNAL MAGNETIC FIELD
INTERNAL MAGNETIC FIELD VECTOR
X COMPONENT (Oe)  0.000E+00
Y COMPONENT (Oe)  0.000E+00
Z COMPONENT (Oe)  0.000E+00

**ADDITIONAL ITEMS**
AVERAGE MAGNETIZATION OUTPUT  YES
MAGNETIZATION MOTION  MOTION
☐ CONSIDER THERMAL FLUCTUATION
FIX MAGNETIZATION MOTION ON BOUNDARY
| NORMAL PLANE | PARALLEL PLANE |
SPECIFY VECTOR  NO ▼

| OK | CANCEL |

# FIG.5

# FIG.6

# FIG.7

# FIG.8

# FIG.9

# FIG.10

EP 2 420 853 B1

# FIG.11

# FIG.12

# FIG.13

START

| SET AS n=0 | ~S101 |

| CALCULATE $A^{n+1}$ | ~S102 |

| CALCULATE $H^{n+1} = \dfrac{1}{\mu_o} \nabla \times A^{n+1}$ | ~S103 |

| CALCULATE AVERAGE VALUE $M^{n+1}$ WITH RESPECT TO EXTERNAL MAGNETIC FIELD $H^{n+1}$ | ~S104 |

S105

NO ← IS n GREATER THAN Nall?

YES

S106

| SET AS n=n+1 |

| END CALCULATION | ~S107 |

END

# FIG.14

```
                    ┌─────────────┐
                    │    START    │
                    └──────┬──────┘
                           ↓
            ┌──────────────────────────────┐
            │     SET AS i=0 AND n=0        │───S201
            └──────────────┬───────────────┘
                           ↓
            ┌──────────────────────────────┐
            │       CALCULATE δA           │───S202
            └──────────────┬───────────────┘
                           ↓
            ┌──────────────────────────────┐
            │  CALCULATE Aⁿ⁺¹ᵢ₊₁=Aⁿ⁺¹ᵢ+δA │───S203
            └──────────────┬───────────────┘
                           ↓         S204
```

$$\text{CALCULATE } A^{n+1}_{i+1} = A^{n+1}_{i} + \delta A \quad \text{S203}$$

**S204**: IS $|\delta A|$ GREATER THAN $\varepsilon$ ?  NO

**S205**: CALCULATE $H^{n+1}_{i+1} = \dfrac{1}{\mu_o} \nabla \times A^{n+1}_{i+1}$

**S208**: SET AS $A^{n+1} = A^{n+1}_{i+1}$

**S206**: CALCULATE AVERAGE VALUE $M^{n+1}_{i+1}$ WITH RESPECT TO EXTERNAL MAGNETIC FIELD $H^{n+1}_{i+1}$

**S207**: SET AS i=i+1

**S209**: IS n GREATER THAN Nall?  NO

**S210**: SET AS i=0 AND n=n+1

**S211**: END CALCULATION

END

YES

YES

# FIG.15

START

INITIALIZE AS i=0, n=0, $\Delta M/\Delta H=0$, AND $\alpha=3$ ——S301

CALCULATE $\delta A$ ——S302

CALCULATE $A^{n+1}{}_{i+1}=A^{n+1}{}_i+\delta A$ ——S303

S304

IS $|\delta A|$ GREATER THAN $\varepsilon$ ? —— NO

YES

CALCULATE $H^{n+1}{}_{i+1}=\dfrac{1}{\mu_o}\nabla\times A^{n+1}{}_{i+1}$ ——S305

CALCULATE AVERAGE VALUE $M^{n+1}{}_{i+1}$ WITH RESPECT TO EXTERNAL MAGNETIC FIELD $H^{n+1}{}_{i+1}$ ——S306

IF i=0, CALCULATE ; $\Delta H=\dfrac{1}{\mu_o}\nabla\times\delta A$

IF i0, CALCULATE $\Delta M/\Delta H$ USING

$\Delta H=\dfrac{1}{\mu_o}\nabla\times(A^{n+1}-A^n)$ ——S307

SET AS $A^{n+1}=A^{n+1}{}_{i+1}$ ——S309

SET AS i=i+1 ——S308

S310

IS n GREATER THAN Nall? —— NO

S311

SET AS i=0 AND n=n+1

YES —— S312

END CALCULATION

END

33

# FIG.16

# FIG.17

**EP 2 420 853 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008275403 A

- US 20050075818 A1

**Non-patent literature cited in the description**

- Efficient techniques for the computer simulation of magnetic recording in complex layered materials. *Journal of Applied Physics,* vol. 95 (6), 3175

- Recording at large Write Currents on Obliquely Evaporated Medium and Application to a Multilevel Recording Scheme. *IEEE Transactions on Magnetics,* December 2010, vol. 46 (12